# EUROPEAN PATENT APPLICATION

(11) **EP 4 757 569 A1**
(43) Date of publication of application: **10.06.2026**
(21) Application number: 25214571.9
(22) Date of filing: 10.11.2025
(51) Int. Cl.: H10P 72/00

(54) **SUBSTRATE PROCESSING APPARATUS**

(30) Priority: 13.11.2024 JP 2024197809
(71) Applicant: SCREEN Holdings Co., Ltd., Kyoto-shi, Kyoto 602-8585 (JP)
(72) Inventor: ABE, Toshihiro, Kyoto, 602-8585 (JP); SHINOHARA, Tomoyuki, Kyoto, 602-8585 (JP); FUNAHASHI, Kazuma, Kyoto, 602-8585 (JP); ABE, Hiroyuki, Kyoto, 602-8585 (JP); IKEMOTO, Hikari, Kyoto, 602-8585 (JP)
(74) Representative: Kilian Kilian & Partner mbB

(57) **Abstract**

A brush device is attachable to and detachable from a brush holder. The brush holder is moved by a movement device. A brush of the brush device is pressed against an upper surface of a substrate held by a substrate holding device, and the substrate is cleaned. In a substrate cleaning device, with one brush device attached to the brush holder, another brush device is stored in a brush storage device. The brush holder is moved by a movement device to the brush storage device after an old brush device is detached. Another brush device is attached to the brush holder. The movement device includes an arm rotation driver and an arm movement driver that move the brush holder in two respective different directions.

## Description

### BACKGROUND

### Technical Field

The present disclosure relates to a substrate processing apparatus that brings a cleaner into contact with a substrate to clean the substrate.

### Description of Related Art

A substrate processing apparatus is used to execute various processes on a substrate such as a semiconductor substrate, a substrate for an FPD (Flat Panel Display) that is used for a liquid crystal display device, an organic EL (Electro Luminescence) display device or the like, a substrate for an optical disc, a substrate for a magnetic disc, a substrate for a magneto-optical disc, a substrate for a photomask, a ceramic substrate or a substrate for a solar cell.

As one example of the substrate processing apparatus, JP 2024-119352 A describes a substrate processing apparatus that cleans a substrate using a brush. The substrate processing apparatus includes a holding rotator, a brush, a brush holder, an arm, a lifting-lowering mechanism and a turn driver. The holding rotator rotates a substrate around a vertical axis while holding the substrate in a horizontal posture. The brush holder is provided at a tip portion of the arm, and attachably and detachably holds the brush.

The arm is lifted and lowered by the lifting-lowering mechanism and the turn driver, and rotates about a vertical axis. The arm moves with the brush attached to the brush holder, so that the brush slides on the substrate. Thus, the substrate is cleaned.

The brush used for cleaning is contaminated or worn according to a usage state. An excessively contaminated or worn brush cannot appropriately clean the substrate. As such, the above-mentioned substrate processing apparatus further includes a brush collector and a brush attacher as configurations for replacing the brush to be held by the brush holder.

When the brush is replaced, the used brush is collected from the brush holder by the brush collector. Thereafter, in the brush attacher, an unused brush stored in advance is attached to the brush holder.

### SUMMARY

The substrate processing apparatus described in JP 2024-119352 A further includes a waiting pod for accommodating a brush during waiting in addition to the plurality of above-mentioned constituent elements. In the substrate processing apparatus, the holding rotator, the brush collector, the brush attacher and the waiting pod, described above, need to be arranged, in plan view, on the path of the brush holder that moves with the rotation of the arm. Such limitation on the layout of the plurality of constituent elements makes it difficult to miniaturize the substrate processing apparatus. Alternatively, it restricts enhancement of the functions of the substrate processing apparatus.

An object of the present disclosure is to provide a substrate processing apparatus in which a substrate can be cleaned by a cleaner and the cleaner can be replaced and which has an improved degree of freedom of layout of a plurality of constituent elements.

A substrate processing apparatus according to one aspect of the present disclosure includes a substrate holder that holds a substrate, a first cleaner and a second cleaner that respectively have first connected portions, a first cleaner holder that has a first connecting portion, the first connecting portion being attachable to and detachable from the first connected portions of the first cleaner and the second cleaner, a first cleaner storage that is provided outside of the substrate holder and temporarily stores the second cleaner, a first holder movement device that moves the first cleaner holder, and a controller that controls the first holder movement device with the first cleaner holder holding the first cleaner to clean the substrate held by the substrate holder, and after the first cleaner used for cleaning the substrate is detached from the first cleaner holder, controls the first holder movement device to connect the first connecting portion of the first cleaner holder to the first connected portion of the second cleaner temporarily stored in the first cleaner storage, wherein the first holder movement device includes a first driver and a second driver that respectively move the first cleaner holder in a first direction and a second direction that are different from each other.

With the present disclosure, in a substrate processing apparatus in which a substrate can be cleaned by a cleaner and the cleaner can be replaced, a degree of freedom of layout of a plurality of constituent elements is improved.

Other features, elements, characteristics, and advantages of the present disclosure will become more apparent from the following description of preferred embodiments of the present disclosure with reference to the attached drawings.

### BRIEF DESCRIPTION OF THE DRAWING

Fig. 1 is a schematic plan view of a substrate cleaning device according to one embodiment of the present disclosure;
Fig. 2 is a diagram for explaining a state of the substrate cleaning device 1 of Fig. 1 before a brush cleaning process for a substrate;
Fig. 3 is a diagram for explaining the basic work during the brush cleaning process for a substrate in the substrate cleaning device of Fig. 1;
Fig. 4 is a diagram for explaining the basic work during a process of replacing a brush device in the substrate cleaning device of Fig. 1;
Fig. 5 is a diagram for explaining the basic work during the process of replacing a brush device in the substrate cleaning device of Fig. 1;
Fig. 6 is an external perspective view of a brush device;
Fig. 7 is a longitudinal cross sectional view of the brush device of Fig. 6;
Fig. 8 is an external perspective view of a brush device connecting portion;
Fig. 9 is a longitudinal cross sectional view of the brush device connecting portion of Fig. 8;
Fig. 10 is an external perspective view for explaining the work performed when a brush device is held by the brush device connecting portion;
Fig. 11 is a longitudinal sectional view showing the brush device connecting portion holding a brush device;
Fig. 12 is a cross sectional view of Fig. 11 taken along the line A-A;
Fig. 13 is a diagram for explaining the work performed when a brush device held by the brush device connecting portion is detached;
Fig. 14 is a block diagram showing the configuration of a control system of the substrate cleaning device of Fig. 1;
Fig. 15 is a schematic plan view showing one example of the substrate processing apparatus including the substrate cleaning device of Fig. 1;
Fig. 16 is a schematic plan view of a substrate cleaning device according to another embodiment;
Fig. 17 is a block diagram showing the configuration of a control system of the substrate cleaning device of Fig. 16; and
Fig. 18 is a schematic plan view of a substrate cleaning device according to yet another embodiment.

### DETAILED DESCRIPTION

A substrate processing apparatus according to one embodiment of the present disclosure will be described below with reference to the drawings. In the following description, a substrate refers to a substrate for an FPD (Flat Panel Display) that is used for a liquid crystal display device, an organic EL (Electro Luminescence) display device or the like, a semiconductor substrate, a substrate for an optical disc, a substrate for a magnetic disc, a substrate for a magneto-optical disc, a substrate for a photomask, a ceramic substrate, a substrate for a solar cell or the like.

In the present embodiment, a substrate is circular, in plan view, except for a portion in which a notch is formed. Further, the substrate has a front surface that is a circuit forming surface and a back surface that is opposite to the circuit forming surface. In the following description, regardless of the front surface and the back surface of the substrate, the surface facing upwardly out of two surfaces of the substrate is referred to as an upper surface of the substrate.

The below-mentioned substrate processing apparatus is a substrate cleaning device that executes a cleaning process (hereinafter referred to as a brush cleaning process) using a brush on a substrate to be processed. During the brush cleaning process, a brush is pressed against the upper surface of a substrate while a predetermined cleaning liquid is supplied to the upper surface of the substrate. Further, in the below-mentioned substrate cleaning device, in a case in which more appropriate cleaning power cannot be obtained because a brush used for cleaning a substrate is contaminated, worn, etc, a process of replacing a brush is executed.

### 1. Overall Configuration of Substrate Cleaning Device

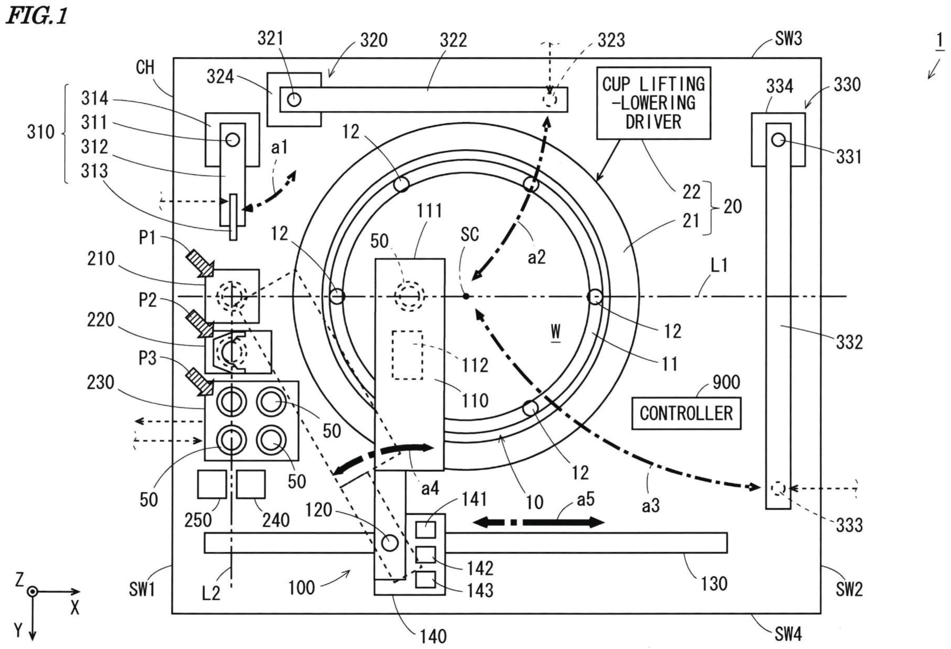

Fig. 1 is a schematic plan view of a substrate cleaning device according to one embodiment of the present disclosure. Fig. 1 and subsequent predetermined diagrams are accompanied by arrows that indicate X, Y and Z directions orthogonal to one another for the clarity of a positional relationship. The X and Y directions are orthogonal to each other within a horizontal plane, and the Z direction corresponds to an upward-and-downward direction (vertical direction).

In regard to the X direction, in a case in which the direction in which the arrow is directed is distinguished from the direction opposite to the direction in which the arrow is directed, the direction in which the arrow is directed is referred to as a + X direction, and the direction opposite to the + X direction is referred to as a - X direction. Further, in regard to the Y direction, in a case in which the direction in which the arrow is directed is distinguished from the direction opposite to the direction in which the arrow is directed, the direction in which the arrow is directed is referred to as a + Y direction, and the direction opposite to the + Y direction is referred to as a - Y direction. Further, in regard to the Z direction, in a case in which the direction in which the arrow is directed is distinguished from the direction opposite to the direction in which the arrow is directed, the direction in which the arrow is directed is referred to as a + Z direction, and the direction opposite to the + Z direction is referred to as a - Z direction.

As shown in Fig. 1, the substrate cleaning device 1 is configured to accommodate a plurality of constituent elements in one chamber CH, and includes a substrate holding device 10, a cup device 20, a liquid supply device 310, a gas supply device 320 and a spray device 330. Further, the substrate cleaning device 1 includes a plurality of brush devices 50, a brush arm device 100, a waiting pod 210, a brush discarder 220, a brush storage device 230, a storage state detector 240, a brush shape detector 250 and a controller 900.

The chamber CH has four sidewalls, a ceiling portion and a bottom portion (bottom surface portion). In one sidewall of the chamber CH, a transfer opening (not shown) for transferring a substrate between the inside of the chamber CH and the outside of the chamber CH is formed. In the following description, in a case in which the four sidewalls of the chamber CH are distinguished from one another, the sidewalls located in the - X direction, the + X direction, the - Y direction and the + Y direction with respect to the center of the chamber CH in plan view are referred to as a first sidewall SW1, a second sidewall SW2, a third sidewall SW3 and a fourth sidewall SW4, respectively.

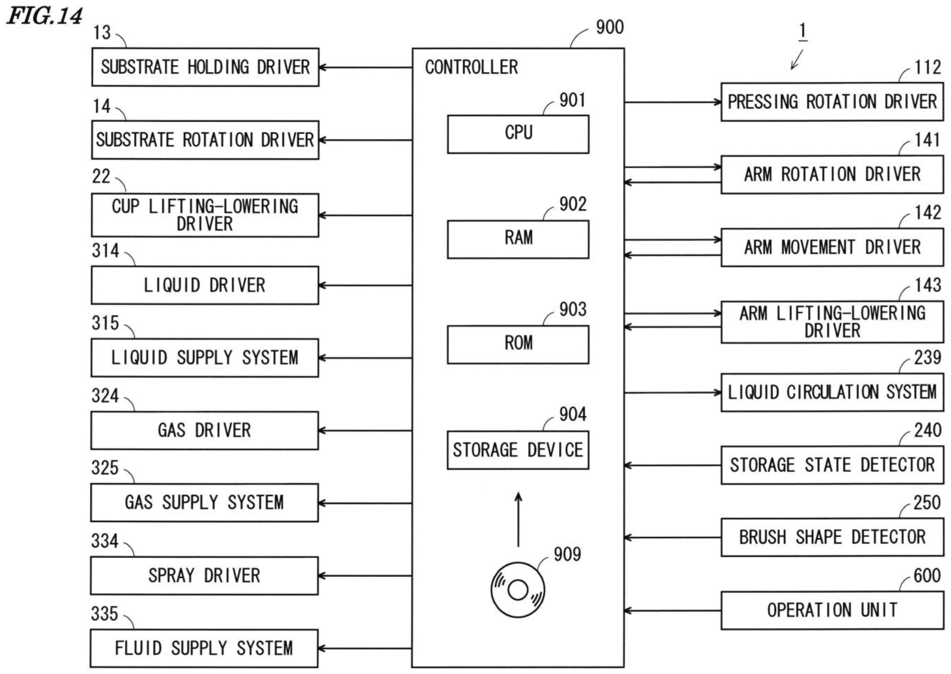

The substrate holding device 10 is provided at substantially the center of the bottom surface of the chamber CH. The substrate holding device 10 includes a spin base 11, a plurality of holding pins 12, a substrate holding driver 13 (Fig. 14) and a substrate rotation driver 14 (Fig. 14). The substrate rotation driver 14 is a motor, for example, and is fixed to the bottom surface of the chamber CH such that a rotation shaft is directed upwardly. The disc-shaped spin base 11 is attached to the upper end portion of the rotation shaft.

The spin base 11 has an outer diameter larger than that of the substrate W to be processed. The plurality of holding pins 12 are provided in a peripheral portion of the upper surface of the spin base 11. Each of the plurality of holding pins 12 has an abutment portion. With the substrate W arranged on the spin base 11, each holding pin 12 is configured to be changeable between a holding state in which the abutment portion abuts against the outer peripheral end of the substrate W and a release state in which the abutment portion is spaced apart from the substrate W. The substrate holding driver 13 includes a magnet, for example, and switches each holding pin 12 between the holding state and the release state using a magnetic force of the magnet. The plurality of holding pins 12 in the holding state abut against a plurality of portions of the outer peripheral end of the substrate W, whereby the substrate W is held on the spin base 11.

The cup device 20 includes a cup body 21 and a cup lifting-lowering driver 22. The cup body 21 has a substantially cylindrical shape, and is provided so as to surround the spin base 11 and extend in the Z direction in plan view. Further, the cup body 21 is provided so as to be movable in the Z direction.

The cup lifting-lowering driver 22 includes an actuator such as a motor or an air cylinder, and moves the cup body 21 between a predetermined cup upper position and a predetermined cup lower position. The cup upper position is a height position (position in the Z direction) at which the upper end portion of the cup body 21 is higher than the substrate W held by the substrate holding device 10. The cup lower position is a height position at which the upper end portion of the cup body 21 is lower than the substrate W held by the substrate holding device 10.

The liquid supply device 310 includes a rotation shaft 311, an arm 312, a liquid nozzle 313, a liquid driver 314 and a liquid supply system 315 (Fig. 14). The rotation shaft 311 is located in the vicinity of one corner portion (the corner portion between the first sidewall SW1 and the third sidewall SW3 in the present example) of the four corners of the chamber CH. The rotation shaft 311 extends in the Z direction, and is supported by the liquid driver 314 to be movable in the Z direction and rotatable. The arm 312 is provided to extend by a certain distance in a horizontal direction from the upper end portion of the rotation shaft 311.

The liquid driver 314 includes one or a plurality of pulse motors, one or a plurality of air cylinders and the like, lifts and lowers the rotation shaft 311 and rotates the rotation shaft 311. When the rotation shaft 311 rotates, the arm 312 rotates about the rotation shaft 311 as indicated by the thick one-dot and dash arrow a1 in Fig. 1. The liquid nozzle 313 is attached to the tip portion of the arm 312.

The liquid nozzle 313 has a discharge port directed toward a rotation center SC of the spin base 11 with the arm 312 held at a predetermined height position and with the tip portion of the arm 312 directed toward the rotation center SC of the spin base 11 in plan view.

The liquid supply system 315 (Fig. 14) is connected to the liquid nozzle 313. During the below-mentioned brush cleaning process for the substrate W, the liquid driver 314 rotates the rotation shaft 311 such that the discharge port of the liquid nozzle 313 is directed toward the upper surface of the substrate W held by the substrate holding device 10. In this state, the liquid supply system 315 supplies a cleaning liquid to the liquid nozzle 313. Thus, the cleaning liquid is discharged from the liquid nozzle 313 to the substrate W. In the present embodiment, pure water (deionized water) is used as the cleaning liquid to be supplied to the liquid nozzle 313.

The gas supply device 320 includes a rotation shaft 321, an arm 322, a gas nozzle 323, a gas driver 324 and a gas supply system 325 (Fig. 14). The rotation shaft 321 is located in the vicinity of one corner portion (the corner portion between the first sidewall SW1 and the third sidewall SW3 in the present example) of the four corners of the chamber CH. The rotation shaft 321 extends in the Z direction, and is supported by the gas driver 324 to be movable in the Z direction and rotatable. The arm 322 is provided to extend by a certain distance in the horizontal direction from the upper end portion of the rotation shaft 321.

The gas driver 324 includes one or a plurality of pulse motors, one or a plurality of air cylinders and the like, lifts and lowers the rotation shaft 321 and rotates the rotation shaft 321. When the rotation shaft 321 rotates, the arm 322 rotates about the rotation shaft 321 as indicated by the thick one-dot and dash arrow a2 in Fig. 1. The gas nozzle 323 is attached to the tip portion of the arm 322.

The gas nozzle 323 has an injection port directed toward the rotation center SC of the spin base 11 with the arm 322 held at a predetermined height position and with the tip portion of the arm 322 directed toward the rotation center SC of the spin base 11 in plan view.

The gas supply system 325 (Fig. 14) is connected to the gas nozzle 323. When the wet substrate W is dried, the gas driver 324 rotates the rotation shaft 321 such that the injection port of the gas nozzle 323 is directed toward the upper surface of the substrate W held by the substrate holding device 10. In this state, the gas supply system 325 supplies a gas to the gas nozzle 323. Thus, the gas is injected from the gas nozzle 323 to the substrate W. In the present embodiment, an inert gas such as nitrogen or argon is used as a gas to be supplied to the gas nozzle 323.

The spray device 330 includes a rotation shaft 331, an arm 332, a spray nozzle 333, a spray driver 334 and a fluid supply system 335 (Fig. 14). The rotation shaft 331 is located in the vicinity of another corner portion (the corner portion between the second sidewall SW2 and the third sidewall SW3 in the present example) of the four corners of the chamber CH. The rotation shaft 331 extends in the Z direction, and is supported by the spray driver 334 to be movable in the Z direction and rotatable. The arm 332 is provided to extend by a certain distance in the horizontal direction from the upper end portion of the rotation shaft 331.

The spray driver 334 includes one or a plurality of pulse motors, one or a plurality of air cylinders and the like, lifts and lowers the rotation shaft 331 and rotates the rotation shaft 331. When the rotation shaft 331 rotates, the arm 332 rotates about the rotation shaft 331 as indicated by the thick one-dot and dash arrow a3 in Fig. 1. The spray nozzle 333 is attached to the tip portion of the arm 332.

The spray nozzle 333 has an injection port directed toward the rotation center SC of the spin base 11 with the arm 332 held at a predetermined height position and with the tip portion of the arm 332 directed toward the rotation center SC of the spin base 11 in plan view.

The fluid supply system 335 (Fig. 14) is connected to the spray nozzle 333. During a spray cleaning process for the substrate W, described below, the spray driver 334 rotates the rotation shaft 331 such that the injection port of the spray nozzle 333 is directed toward the upper surface of the substrate W held by the substrate holding device 10. In this state, the fluid supply system 335 supplies a cleaning liquid and a gas to the spray nozzle 333.

In the spray nozzle 333, the cleaning liquid and the gas supplied from the fluid supply system 335 are mixed. Thus, a fluid mixture of liquid droplets of the cleaning liquid and the gas is injected from the injection port of the spray nozzle 333. The spray nozzle 333 is moved in an arc shape while injecting the fluid mixture above the upper surface of the substrate W which is held by suction and rotated by the substrate holding device 10. Thus, the entire upper surface of the substrate W can be cleaned. In the present embodiment, pure water (deionized water) is used as a cleaning liquid to be supplied to the spray nozzle 333, and an inert gas such as nitrogen or argon is used as a gas to be supplied to the spray nozzle 333.

The brush arm device 100 includes a brush arm 110, a rotation shaft 120, a guide rail 130 and an arm supporter 140. In the chamber CH, the guide rail 130 is provided to be adjacent to the substrate holding device 10 in the Y direction. The guide rail 130 extends in the X direction.

The arm supporter 140 is provided on the guide rail 130. The arm supporter 140 is movable in the X direction along the guide rail 130. The rotation shaft 120 extends in the Z direction, and is supported by the arm supporter 140 so as to be movable in the Z direction and rotatable. The brush arm 110 is provided to extend by a certain distance in the horizontal direction from the upper end portion of the rotation shaft 120.

An arm rotation driver 141, an arm movement driver 142 and an arm lifting-lowering driver 143 are built in the arm supporter 140. The arm rotation driver 141 is a pulse motor, for example, and rotates the rotation shaft 120 about the center axis thereof based on the control of the controller 900, described below. When the rotation shaft 120 rotates, the brush arm 110 rotates about the rotation shaft 120 as indicated by the thick one-dot and dash arrow a4 in Fig. 1.

An encoder that outputs a signal corresponding to a rotation angle of the rotation shaft 120 is built in the arm rotation driver 141. Further, in the brush arm device 100, an origin detection sensor for detecting an origin position of a rotation angle of the rotation shaft 120 is provided as a constituent element associated with the arm rotation driver 141. For example, the origin detection sensor is a photoelectric sensor that is turned on or off when the brush arm 110 is in a specific posture (an orientation of the brush arm 110 in plan view), and is turned off or on when the brush arm 110 is in another posture.

The arm movement driver 142 is a pulse motor, for example, and moves the arm supporter 140 in the X direction (see the thick one-dot and dash arrow a5 of Fig. 1) based on the control of the controller 900, described below. An encoder that outputs a signal corresponding to a position of the arm supporter 140 in the X direction is built in the arm movement driver 142. Further, in the brush arm device 100, an origin detection sensor for detecting an origin position of the arm supporter 140 in the X direction is provided as a constituent element associated with the arm movement driver 142. For example, the origin detection sensor is a photoelectric sensor that is turned on or off when the arm supporter 140 is at a specific position in the X direction, and is turned off or on when the arm supporter 140 is in another position in the X direction.

The arm lifting-lowering driver 143 is a pulse motor, for example, and moves the rotation shaft 120 in the Z direction based on the control of the controller 900, described below. Thus, the brush arm 110 is lifted and lowered. An encoder that outputs a signal corresponding to a height position (position in the Z direction) of the brush arm 110 is built in the arm lifting-lowering driver 143. Further, in the brush arm device 100, an origin detection sensor for detecting an origin position of the brush arm 110 in the Z direction is provided as a constituent element associated with the arm lifting-lowering driver 143. For example, the origin detection sensor is a photoelectric sensor that is turned on or off when the brush arm 110 is at a specific position in the Z direction, and is turned off or on when the brush arm 110 is at another position in the Z direction.

The tip portion of the brush arm 110 is configured to be capable of holding and detaching (attaching and detaching) the brush device 50 used for cleaning the substrate W as the brush holder 111. Details of the brush device 50 will be described below.

A pressing rotation driver 112 is built in the brush arm 110. The pressing rotation driver 112 includes a plurality of actuators such as an air cylinder and a motor. The pressing rotation driver 112 applies a downward (- Z direction) pressing force to the brush device 50 held by the brush holder 111 based on the control of the controller 900, described below. Further, the pressing rotation driver 112 causes the brush device 50 held by the brush holder 111 to rotate (spin) about an axis extending in the Z direction based on the control of the controller 900, described below.

Here, in the substrate cleaning device 1 of Fig. 1, a straight line passing through the rotation center SC of the spin base 11 and extending in the X direction in plan view is defined as a virtual straight line L1. Further, a straight line that is orthogonal to the virtual straight line L1 in plan view, extends in the Y direction and is located between the substrate holding device 10 and the first sidewall SW1 is defined as a virtual straight line L2.

In this case, the brush holder 111 is located on the virtual straight line L1 with the brush arm 110 extending in the - Y direction from the arm supporter 140. Further, between the substrate holding device 10 and the first sidewall SW1 in the X direction, the waiting pod 210, the brush discarder 220 and the brush storage device 230 are arranged in this order in the + Y direction on the virtual straight line L2.

More specifically, the waiting pod 210 is provided between the substrate holding device 10 and the first sidewall SW1 so as to overlap with the virtual straight line L1 in plan view. The brush discarder 220 is provided at a position in the + Y direction of the waiting pod 210 so as to be adjacent to the waiting pod 210. Further, the brush storage device 230 is provided at a position in the + Y direction of the brush discarder 220 so as to be adjacent to the brush discarder 220.

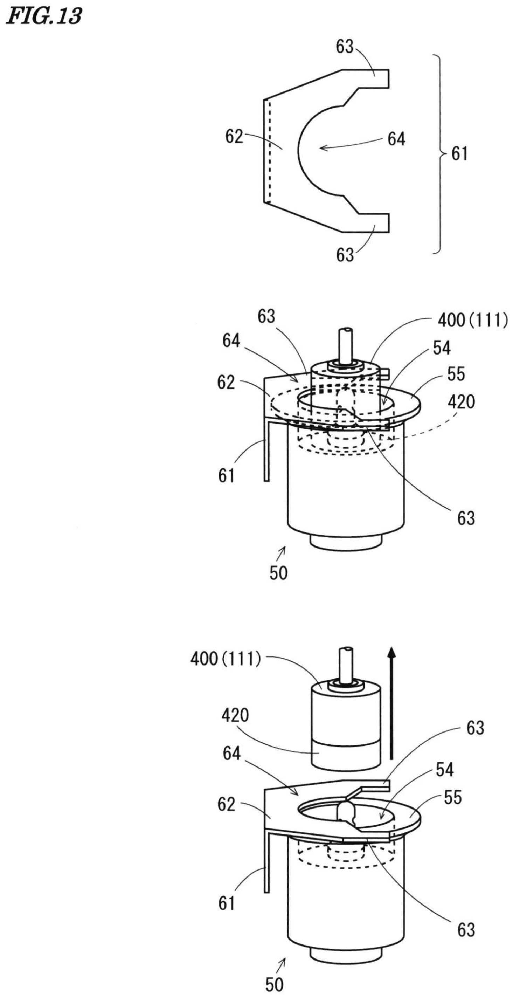

The waiting pod 210 is configured to be capable of accommodating and cleaning the brush device 50 in a clean state, with the brush device 50 being held by the brush holder 111. The brush discarder 220 has a detachment structure 61 (Fig. 13), described below, for detaching the brush device 50 held by the brush holder 111 from the brush holder 111, and is configured to be capable of accommodating the detached brush device 50. The brush storage device 230 is configured to be capable of storing a plurality of unused brush devices 50.

Here, the brush storage device 230 includes a storage tank capable of accommodating a plurality (four, for example) of brush devices 50. Further, the brush storage device 230 includes a liquid circulation system 239 (Fig. 13) that discharges, with a certain amount of a processing liquid being stored in the storage tank, the processing liquid in the storage tank while supplying a new processing liquid into the storage tank. The brush device 50 has a cleaning surface for cleaning the substrate W. The processing liquid supplied to the storage tank is used so as to wet a cleaning surface of an unused brush device 50 stored in the storage tank. The processing liquid stored in the storage tank may be a cleaning liquid used to clean the substrate W. **In** the present embodiment, the processing liquid stored in the storage tank is pure water.

The storage state detector 240 is arranged in the vicinity of the brush storage device 230. The storage state detector 240 includes a detection device such as one or a plurality of photoelectric sensors or a CCD (Charge-Coupled Device) camera, and detects the number of brush devices 50 stored in the brush storage device 230. Further, in a case in which at least one brush device 50 is stored in the brush storage device 230, the storage state detector 240 detects positions of the one or plurality of stored brush devices 50.

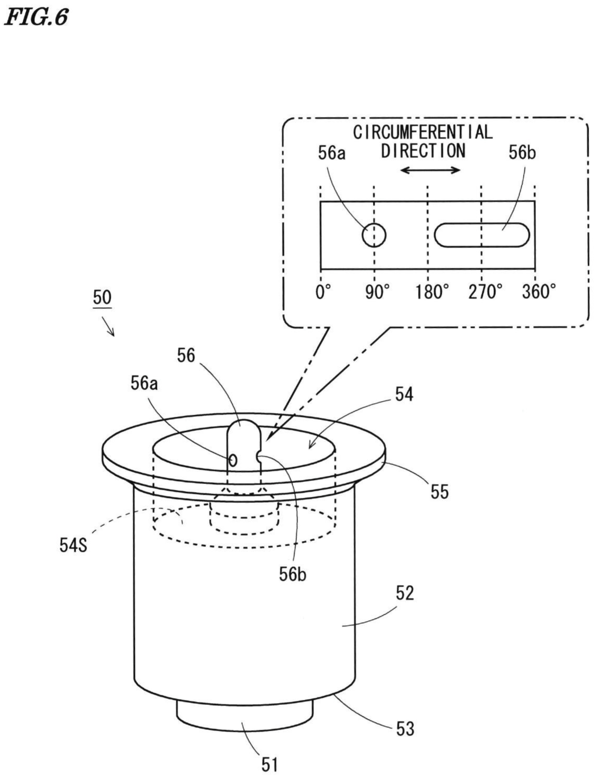

The brush shape detector 250 is arranged in the vicinity of the waiting pod 210, the brush discarder 220 and the brush storage device 230. The brush shape detector 250 includes a detection device such as one or a plurality of photoelectric sensors or a CCD camera. The brush shape detector 250 detects the shape of a brush 51 (Fig. 6) of the brush device 50 held by the brush holder 111 during the below-mentioned process of replacing a brush. The controller 900 controls the work of each component of the substrate cleaning device 1. Details of the controller 900 will be described below.

As indicated by the hatched arrow in Fig. 1, in the substrate cleaning device 1, a waiting position P1 is set at a position overlapping with the waiting pod 210 in plan view. Further, a detachment position P2 is set at a position overlapping with the brush discarder 220 in plan view. Further, an attachment position P3 is set at a position overlapping with the brush storage device 230 in plan view. In plan view, the waiting position P1, the detachment position P2 and the attachment position P3 are arranged on the virtual straight line L2.

### 2. Various Basic Works in Substrate Cleaning Device 1

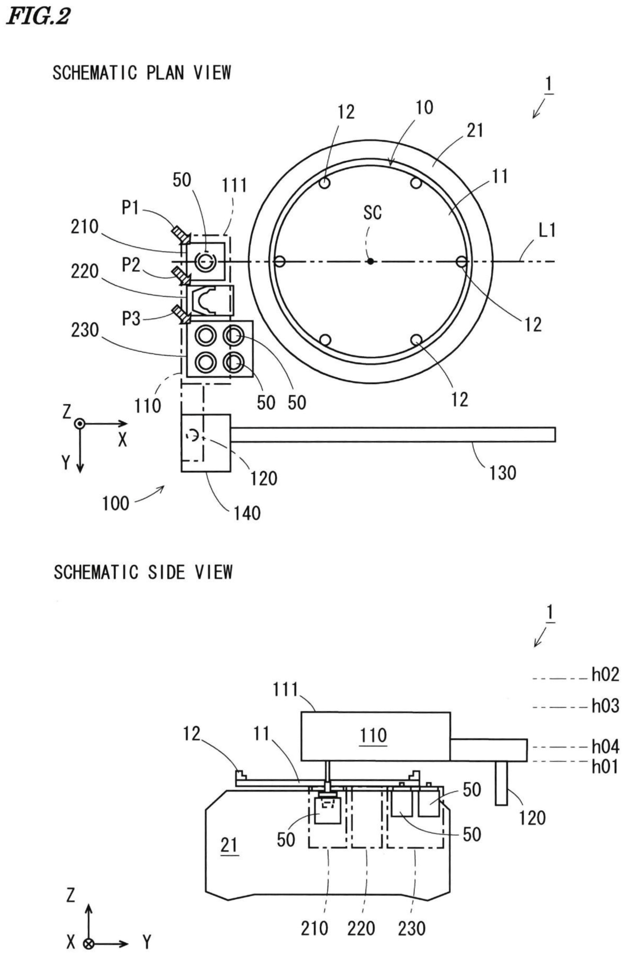

(a) Fig. 2 is a diagram for explaining the state in the substrate cleaning device 1 of Fig. 1 before the brush cleaning process for the substrate W. In Fig. 2, a schematic plan view of the substrate cleaning device 1 is shown in the upper field, and a schematic side view of the substrate cleaning device 1 as viewed in the + X direction is shown in the lower field.

In the plan view in the upper field of Fig. 2, in order to facilitate understanding of the positional relationships among respective constituent elements, the brush arm 110 is indicated by the one-dot and dash lines. Further, in the side view in the lower field of Fig. 2, the waiting pod 210, the brush discarder 220 and the brush storage device 230 are indicated by the one-dot and dash lines.

Before the brush cleaning process is started, the brush holder 111 holding the brush device 50 is arranged at the waiting position P1 in plan view. At this time, the brush arm 110 is supported by the arm supporter 140 so as to extend in the Y direction. Further, the brush device 50 is accommodated in the waiting pod 210. In this manner, a height position (position in the Z direction) of the brush arm 110 in a waiting state is referred to as a waiting height h01.

Further, in a case in which the substrate W is not carried into the substrate cleaning device 1, the cup body 21 is located at the cup lower position. In the waiting state of Fig. 2, suppose that four brush devices 50 are stored in the brush storage device 230.

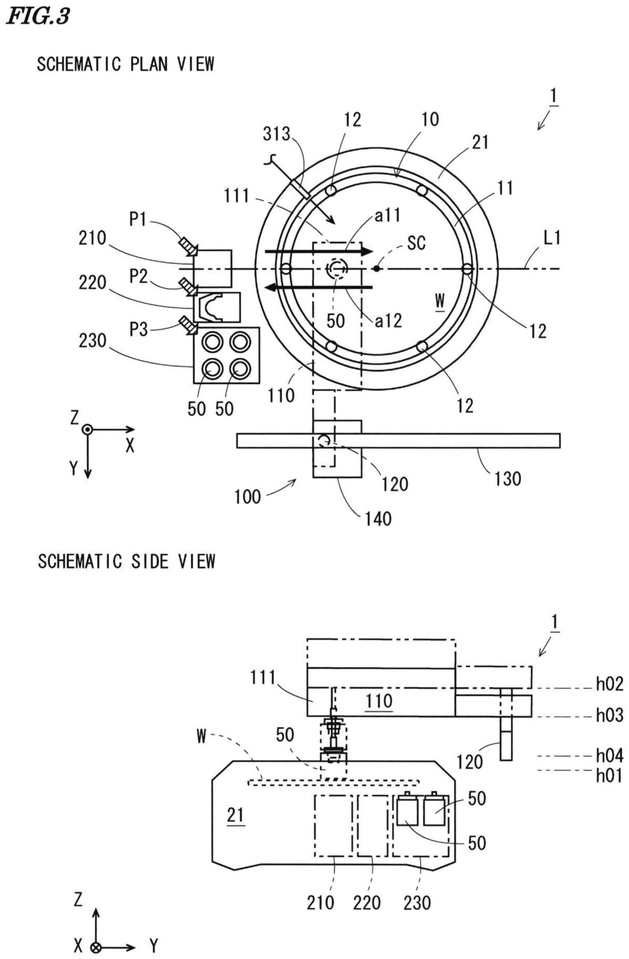

(b) Fig. 3 is a diagram for explaining the basic work during the brush cleaning process for the substrate W in the substrate cleaning device 1 of Fig. 1. In Fig. 3, as in the example of Fig. 2, a schematic plan view of the substrate cleaning device 1 is shown in the upper field, and a schematic side view of the substrate cleaning device 1 is shown in the lower field. Further, in the plan view in the upper field of Fig. 3, the brush arm 110 is indicated by the one-dot and dash lines. Further, in the side view in the lower field of Fig. 3, the waiting pod 210, the brush discarder 220 and the brush storage device 230 are indicated by the one-dot and dash lines.

When the brush cleaning process for the substrate W is started, the substrate W carried into the substrate cleaning device 1 is held by the substrate holding device 10 and rotated at a predetermined rotation speed. Further, the cup body 21 is held at the cup upper position. Further, a cleaning liquid is discharged toward the rotating substrate W from the liquid nozzle 313 of the liquid supply device 310 of Fig. 1.

In this state, the arm movement driver 142 and the arm lifting-lowering driver 143 of Fig. 1 work, whereby the brush arm 110 is moved in the Z direction and the X direction. Thus, the brush device 50 held by the brush holder 111 is lifted up from the waiting pod 210 and moved to a position above the upper surface of the substrate W. Further, the brush device 50 spins while being pressed against the upper surface of the rotating substrate W with a predetermined pressing force by the pressing rotation driver 112 of Fig. 1. In this state, as indicated by the thick solid arrows a11 and a12 in Fig. 3, the brush device 50 is moved in the X direction along the virtual straight line L1 in plan view. In this manner, the upper surface of the substrate W is cleaned.

In a case in which the brush device 50 moves from the inside of the waiting pod 210 onto the substrate W, the brush arm 110 is temporarily lifted to a predetermined height position. The height position of the brush arm 110 at this time is referred to as a movement height h02. Further, the height position of the brush arm 110 when the brush device 50 is pressed against the upper surface of the substrate W is referred to as a cleaning height h03. The movement height h02 is higher than the waiting height h01 and the cleaning height h03.

When the upper surface of the substrate W is cleaned, the brush device 50 is returned to a position of an initial state. That is, as shown in the example of Fig. 2, the brush holder 111 moves to the waiting position P1, and the brush device 50 is accommodated in the waiting pod 210. Further, the discharge of the cleaning liquid by the liquid nozzle 313 is stopped, and the rotation of the substrate W by the substrate holding device 10 is stopped. Further, the cup body 21 moves from the cup upper position to the cup lower position. Thus, the brush cleaning process for the substrate W ends.

Although moving back and forth between the outer peripheral end of the substrate W and the rotation center SC of the spin base 11 in the example of Fig. 3, the brush device 50 may clean the substrate W by moving from one end portion to the other end portion of the substrate W along the virtual straight line L1. Alternatively, the brush device 50 may clean the substrate W by moving between the outer peripheral end of the substrate W and the rotation center SC of the spin base 11 only once.

(c) As described above, in the substrate cleaning device 1 according to the present embodiment, the process of replacing a brush used to clean the substrate W is executed. Here, the brush device 50 has the configuration in which the brush 51 (Fig. 6) and a plurality of members associated with the brush 51 are integrally assembled. Therefore, in this substrate cleaning device 1, as a process of replacing the brush 51, a process of replacing a used brush device 50 (old brush device 50) held by the brush holder 111 with an unused brush device 50 (new brush device 50) is executed.

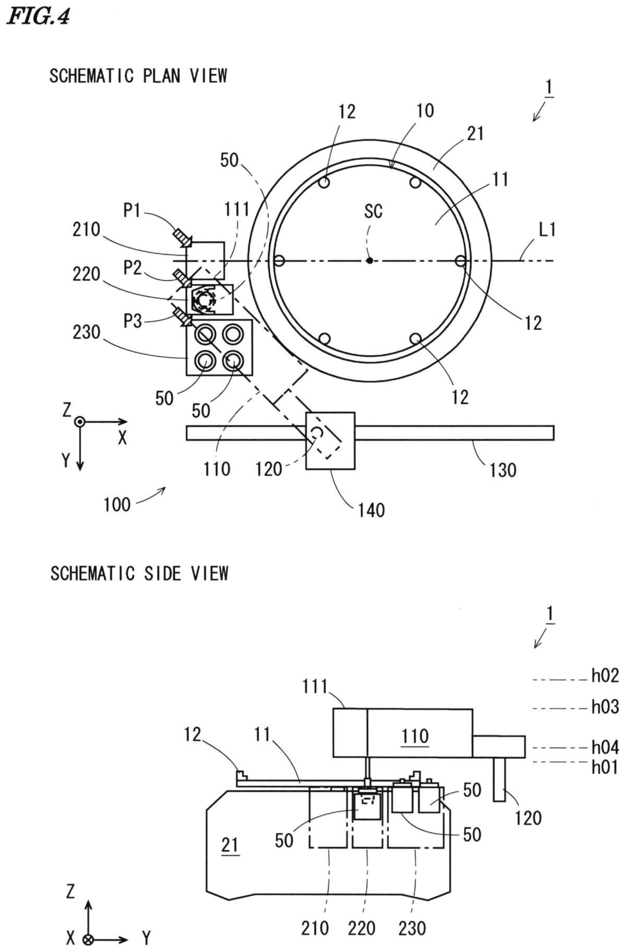

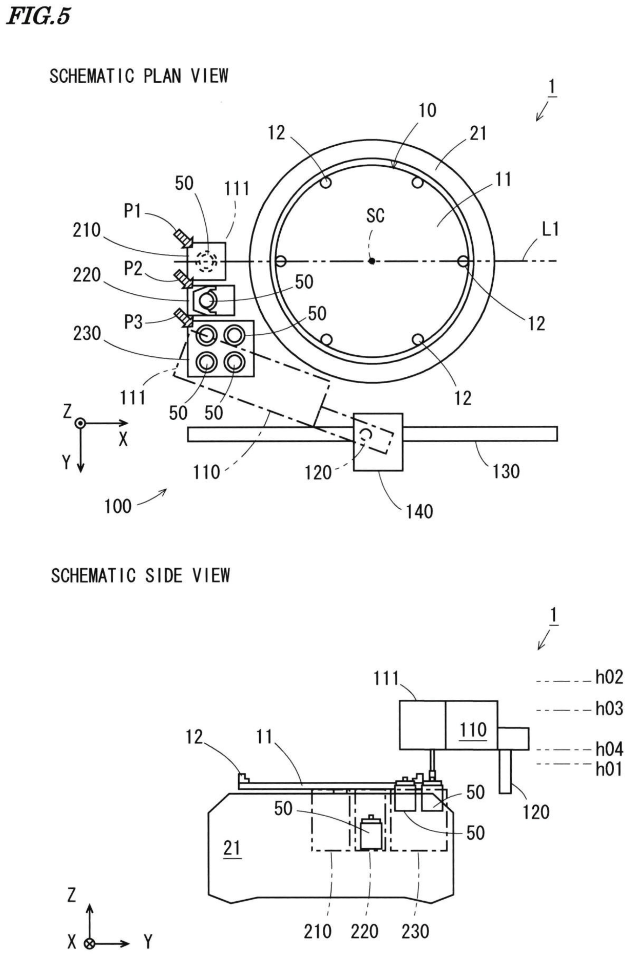

Figs. 4 and 5 are diagrams for explaining the basic work during the process of replacing a brush device 50 in the substrate cleaning device 1 of Fig. 1. In Figs. 4 and 5, as in the examples of Figs. 2 and 3, a schematic plan view of the substrate cleaning device 1 is shown in the upper field, and a schematic side view of the substrate cleaning device 1 is shown in the lower field. Further, in each of the plan views in the upper fields of Figs. 4 and 5, the brush arm 110 is indicated by the one-dot and dash lines. In each of the side views in the lower fields of Figs. 4 and 5, the waiting pod 210, the brush discarder 220 and the brush storage device 230 are indicated by the one-dot and dash lines.

In an initial state before the process of replacing the brush device 50, as shown in Fig. 2, the brush holder 111 holding the used brush device 50 is located at the waiting position P1. The brush device 50 is accommodated in the waiting pod 210. Further, the cup body 21 is located at the cup lower position. Further, in the present example, four unused brush devices 50 are stored in the brush storage device 230.

When the process of replacing the brush device 50 is started, the arm rotation driver 141, the arm movement driver 142 and the arm lifting-lowering driver 143 in Fig. 1 work. Thus, the brush arm 110 rotates about the rotation shaft 120. Further, the brush arm 110 is moved in the Z direction and X direction.

Thus, the brush device 50 held by the brush holder 111 is lifted up from the waiting pod 210. Further, the brush holder 111 moves in the + Y direction at the movement height h02 and reaches the detachment position P2.

At the detachment position P2, the brush arm 110 moves in the - Z direction. As such, in the brush discarder 220, the brush device 50 is detached as described below. Thus, the used brush device 50 is detached from the brush holder 111. The detached brush device 50 is accommodated in the brush discarder 220.

Next, the brush holder 111 not in a state of holding the brush device 50 is lifted again to the movement height h02, and is moved from the detachment position P2 to the attachment position P3 as shown in Fig. 5.

Here, a storage state of the brush device 50 in the brush storage device 230 can be detected by the storage state detector 240 of Fig. 1. Therefore, at the start point in time of the process of replacing the brush device 50, a position of the brush device 50 to be replaced in the brush storage device 230 is recognized in advance.

As such, at the attachment position P3, in plan view, a position of the brush holder 111 in the horizontal direction is adjusted (positioning for the brush holder 111) such that the brush holder 111 overlaps with one brush device 50 stored in the brush storage device 230. In this state, the brush arm 110 is moved in the - Z direction. Thus, one unused brush device 50 stored in the brush storage device 230 is held by the brush holder 111. The height position of the brush arm 110 at this time is referred to as an attachment height h04. The attachment height h04 is lower than the movement height h02 and the cleaning height h03, and is higher than the waiting height h01. The attachment height h04 may be as high as the waiting height h01, or may be lower than the waiting height h01.

Thereafter, the brush device 50 held by the brush holder 111 is lifted up from the brush storage device 230. Further, the brush holder 111 is lifted to the movement height h02 and is then moved to the waiting position P1. Further, the brush holder 111 moves in the - Z direction at the waiting position P1. Thus, the one unused brush device 50 held by the brush holder 111 is accommodated in the waiting pod 210. In this manner, the process of replacing the brush device 50 ends.

(d) In the process of replacing the brush device 50, the shape of the brush 51 of the brush device 50 is detected by the brush shape detector 250 in a period during which the one unused brush device 50 moves from the brush storage device 230 to the waiting pod 210.

A unique three-dimensional coordinate system is defined for the substrate cleaning device 1 according to the present embodiment. Further, in the substrate cleaning device 1, coordinate information of a path along which the brush holder 111 is to move during the brush cleaning process for the substrate W (hereinafter referred to as brush path information) is set in advance. When the shapes of brushes 51 of brush devices 50 vary, a desired portion of the substrate W may not be cleanable even when the brush holder 111 moves based on the preset coordinate information. As such, in the present embodiment, the preset brush path information is corrected based on the above-mentioned detection result of the brush shape detector 250.

(e) As described above, the substrate cleaning device 1 of Fig. 1 includes the spray device 330. Therefore, in the substrate cleaning device 1, before the brush cleaning process for the substrate W, for example, a process of cleaning the substrate W using the spray device 330 (hereinafter referred to as a spray cleaning process) can be executed. Further, the substrate cleaning device 1 of Fig. 1 includes the gas supply device 320. Therefore, in the substrate cleaning device 1, it is possible to supply a gas to the upper surface of the rotating substrate W after the brush cleaning process or after the spray cleaning process, for example. Thus, it is possible to promote drying for the substrate W after the brush cleaning process or after the spray cleaning process.

### 3. Configuration of Brush Device 50

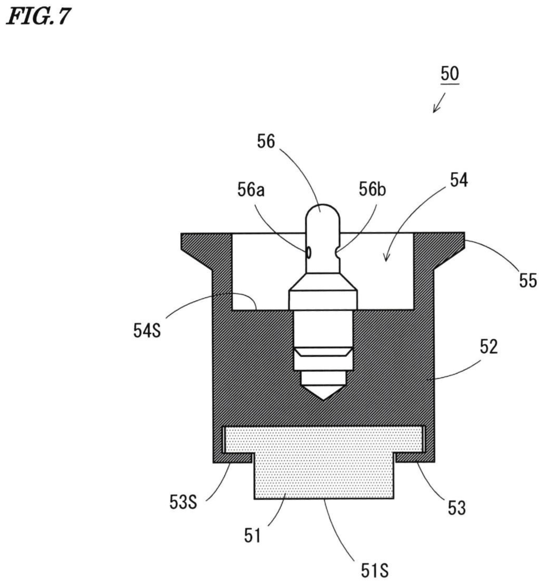

Fig. 6 is an external perspective view of the brush device 50, and Fig. 7 is a longitudinal cross-sectional view of the brush device 50 of Fig. 6. As shown in Fig. 6, the brush device 50 includes a brush 51, a brush support 52 and a connected column 56. The brush support 52 has a substantially cylindrical shape, and has a brush attachment portion 53 in the lower end portion.

The brush 51 is formed of a PVA (polyvinyl alcohol) sponge or a PVA sponge in which abrasive grains are dispersed, for example, and has a circular cleaning surface 51S that can come into contact with the upper surface of the substrate W. As shown in Fig. 7, the brush 51 is attached to the brush attachment portion 53 of the brush support 52 such that the cleaning surface 51S is directed downwardly. The brush attachment portion 53 has an annular supported surface 53S surrounding part of the brush 51 and located upwardly of the cleaning surface 51S by a minute distance with the brush 51 attached to the brush attachment portion 53.

As shown in Fig. 6, a recess portion 54 is formed in the center of the upper end portion of the brush support 52. Further, an annular flange portion 55 is formed in the upper end portion of the brush support 52 so as to project outwardly by a certain distance over the entire circumference of the brush support 52.

The recess portion 54 has a flat bottom surface 54S. A screw hole is formed in the center portion of the bottom surface 54S. The connected column 56 is a bar-shaped member having a circular cross section, and a first groove portion 56a and a second groove portion 56b are formed in the upper half portion of the connected column 56. Further, a male screw corresponding to a screw hole of the bottom surface 54S is formed in the lower half of the connected column 56. The lower half of the connected column 56 is attached to the screw hole of the bottom surface 54S. Thus, the connected column 56 is fixed to the brush support 52 with the upper half portion of the connected column 56 projecting upwardly from the bottom surface 54S of the recess portion 54.

The upper end portion of the connected column 56 is formed in a hemispherical shape. The first groove portion 56a and the second groove portion 56b are formed at positions equidistant from the upper end portion of the connected column 56 in its axial direction. Further, the first groove portion 56a and the second groove portion 56b are formed at different positions in the circumferential direction of the connected column 56.

Fig. 6 shows, in the two-dots and dash balloon, the outer peripheral surface of the upper half portion of the connected column 56 being expanded in the circumferential direction. In the expanded view, angular positions in the circumferential direction with reference to the center axis of the connected column 56 are provided every 90° from 0° to 360°. As shown in the expanded view, the angular range (about 160°) in the circumferential direction where the second groove portion 56b is formed is larger than the angular range (about 45°) in the circumferential direction where the first groove portion 56a is formed.

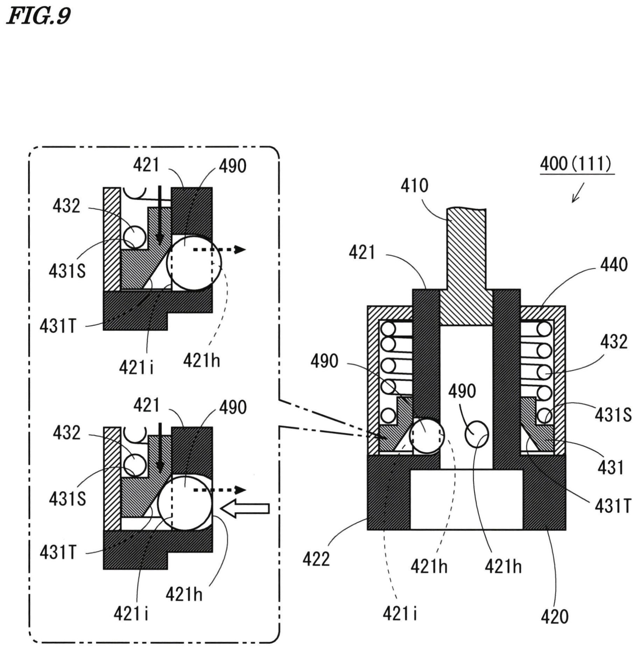

Each of the first groove portion 56a and the second groove portion 56b is formed so as to be capable of accommodating part of a steel ball 490 (Fig. 9), described below, and incapable of accommodating the entire steel ball 490. Further, the second groove portion 56b allows movement of the steel ball 490 in the circumferential direction within a certain angular range with part of the steel ball 490 being accommodated.

### 4. Configuration of Brush Holder 111

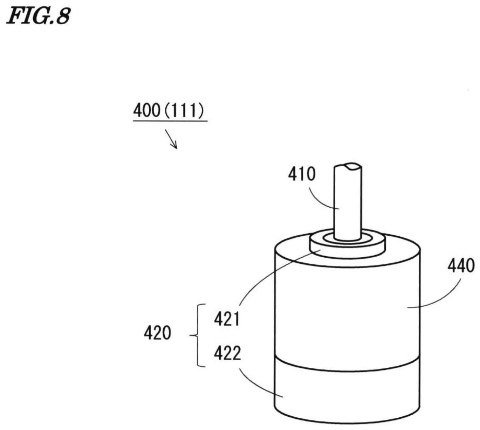

The brush holder 111 of Fig. 1 includes a brush device connecting portion provided to extend in the Z direction (extend downwardly) in the tip portion of the brush arm 110. Fig. 8 is an external perspective view of the brush device connecting portion, and Fig. 9 is a longitudinal cross-sectional view of the brush device connecting portion 400 of Fig. 8. As shown in Fig. 8, the brush device connecting portion 400 includes a shaft member 410, a connection body portion 420 and a casing 440. Further, as shown in Fig. 9, the brush device connecting portion 400 further includes a pressing member 431, a spring 432, and a plurality (three in the present example) of steel balls 490.

The connection body portion 420 has the configuration in which a first cylindrical portion 421 and a second cylindrical portion 422 having different inner diameters and different outer diameters are connected in an axial direction. The first cylindrical portion 421 and the second cylindrical portion 422 are arranged in this order from top to bottom. The inner diameter of the first cylindrical portion 421 is slightly larger than the outer diameter of the connected column 56 of the brush device 50. Further, the inner diameter of the second cylindrical portion 422 is larger than the inner diameter of the first cylindrical portion 421, and the outer diameter of the second cylindrical portion 422 is larger than the outer diameter of the first cylindrical portion 421.

The shaft member 410 is held in the tip portion of the brush arm 110 by the pressing rotation driver 112 of Fig. 1 so as to be rotatable about the axial center of the shaft member 410. The lower end portion of the shaft member 410 is coupled to the upper end portion of the first cylindrical portion 421 and portions in the vicinity of the upper end portion of the first cylindrical portion 421 while being inserted into the first cylindrical portion 421 from above. Thus, the connection body portion 420 is supported by the shaft member 410.

In the vicinity of the lower end portion of the first cylindrical portion 421, a plurality (three in the present example) of through holes arranged at equal angular intervals in the circumferential direction are formed. The opening of each through hole formed in the inner peripheral surface of the first cylindrical portion 421 is referred to as an inner opening 421h. The opening of each through hole formed in the outer peripheral surface of the first cylindrical portion 421 is referred to as an outer opening 421i. Both of the inner opening 421h and the outer opening 421i are circular.

Part of a steel ball 490 is accommodated in each through hole. The thickness of the first cylindrical portion 421 is smaller than the diameter of the steel ball 490. Further, the inner diameter of the inner opening 421h is smaller than the diameter of the steel ball 490. On the other hand, the inner diameter of the outer opening 421i is larger than the diameter of the steel ball 490. With such a configuration, with part of the steel ball 490 being accommodated in the through hole of the first cylindrical portion 421, the remaining part of the steel ball 490 is located at least outwardly of the first cylindrical portion 421 or inwardly of the first cylindrical portion 421.

The cylindrical pressing member 431 having an inner diameter slightly larger than the outer diameter of the first cylindrical portion 421 and an outer diameter smaller than the outer diameter of the second cylindrical portion 422 is fitted to the first cylindrical portion 421. The lower half portion of the inner peripheral surface of the pressing member 431 is inclined with respect to the axial direction of the pressing member 431 such that the inner diameter of the pressing member 431 increases gradually downwardly. The inclined inner peripheral surface of the pressing member 431, as a ball pressing surface 431T, abuts against parts of three steel balls 490 projecting outwardly from the three through holes of the first cylindrical portion 421.

The pressing member 431 has an annular pressed surface 431S that is directed upwardly. A spring 432 is provided on the pressed surface 431S. The spring 432 of the present example is a coil spring and surrounds the first cylindrical portion 421. The casing 440 is provided so as to cover the pressing member 431 and the spring 432 while surrounding the first cylindrical portion 421. The casing 440 is attached to the connection body portion 420 so as to compress the spring 432 from above toward the pressed surface 431S of the pressing member 431. Thus, a pressing force directed toward the second cylindrical portion 422 is exerted on the pressing member 431 from the spring 432.

As described above, the ball pressing surface 431T of the pressing member 431 abuts against parts of the three steel balls 490 projecting outwardly from the three through holes of the first cylindrical portion 421. Therefore, a pressing force applied to the pressing member 431 by the spring 432 is exerted to press the three respective steel balls 490 toward the axial center of the first cylindrical portion 421. That is, a pressing force applied along the axial center of the first cylindrical portion 421 is converted into a pressing force that presses the three steel balls 490 toward the axial center of the first cylindrical portion 421.

Thus, as shown in the upper field of the two-dots and dashed balloon in Fig. 9, in a case in which no force is applied to each steel ball 490 from the inside of the first cylindrical portion 421, part of the steel ball 490 projects inwardly of the first cylindrical portion 421 from the inner opening 421h. On the other hand, as shown in the lower field of the balloon in Fig. 9, suppose that a force directed from the inside of the first cylindrical portion 421 to the outside of the first cylindrical portion 421 is exerted on each steel ball 490. In this case, as indicated by the outlined arrow, when a force directed from the inside of the first cylindrical portion 421 toward the outside of the first cylindrical portion 421 exceeds a force pressing the steel ball 490 inwardly of the first cylindrical portion 421 due to an elastic force of the spring 432, the steel ball 490 is pushed out from the inner space of the first cylindrical portion 421.

### 5. Holding and Detaching of Brush Device 50 by Brush Device Connecting Portion 400

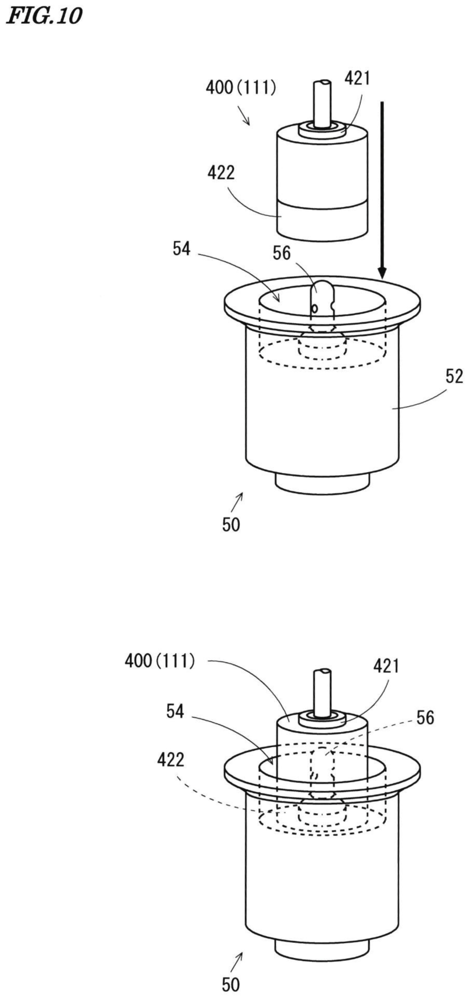

Fig. 10 is an external perspective view for explaining the work when the brush device connecting portion 400 holds the brush device 50. As shown in the upper field of Fig. 10, when the brush device connecting portion 400 holds the brush device 50, the second cylindrical portion 422 of the brush device connecting portion 400 is pushed into the recess portion 54 of the brush device 50 of Fig. 6. Thus, as shown in the lower field of Fig. 10, the brush device 50 is held by the brush device connecting portion 400.

When the brush device connecting portion 400 is pushed in, the connected column 56 of the brush device 50 is inserted into the first cylindrical portion 421 of the brush device connecting portion 400. At this time, in the first cylindrical portion 421, portions of the three steel balls 490 projecting into the first cylindrical portion 421 are gradually pushed outwardly of the first cylindrical portion 421 by the upper end portion of the connected column 56. Thereafter, the connected column 56 further enters the first cylindrical portion 421, and the lower end portion of the second cylindrical portion 422 abuts against the bottom surface 54S of the recess portion 54 of the brush device 50. In this state, portions of the three steel balls 490 are fitted to the first groove portion 56a and the second groove portion 56b of the connected column 56.

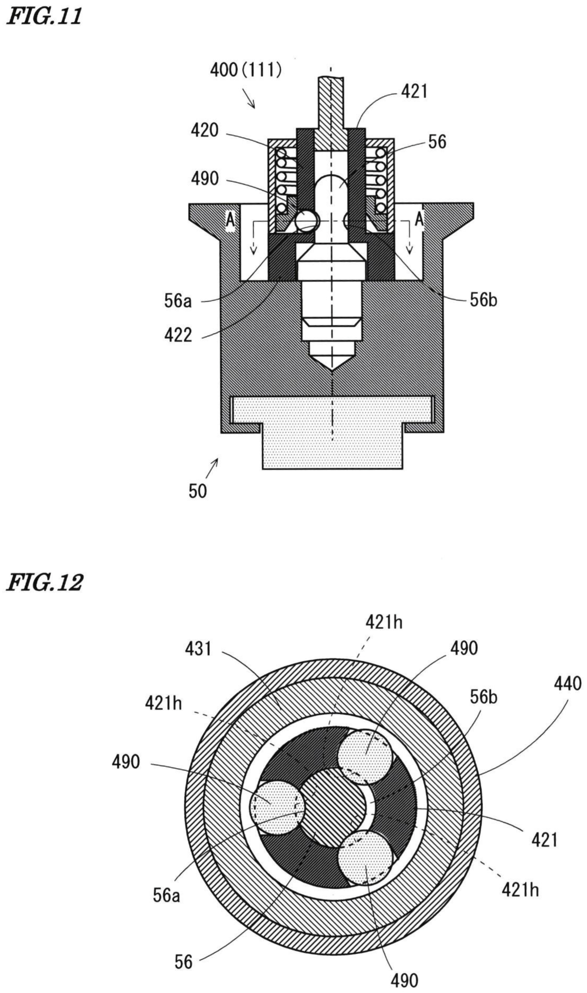

Fig. 11 is a longitudinal cross-sectional view showing the brush device connecting portion 400 holding the brush device 50, and Fig. 12 is a cross-sectional view taken along the line A-A of Fig. 11. As shown in Figs. 11 and 12, part of each steel ball 490 of the brush device connecting portion 400 is fitted to either the first groove portion 56a or the second groove portion 56b of the connected column 56 of the brush device 50. Thus, with the brush device 50 held by the brush device connecting portion 400, an engaging force caused by an elastic force of the spring 432 (Fig. 9) built in the brush device connecting portion 400 is exerted between the brush device connecting portion 400 and the brush device 50.

Fig. 13 is a diagram for explaining the work when the brush device 50 held by the brush device connecting portion 400 is detached. In order to detach the brush device 50 from the brush device connecting portion 400, a detachment structure 61 is required. As described above, the detachment structure 61 is provided in the brush discarder 220 of Fig. 1.

In the upper field of Fig. 13, one example of the detachment structure 61 is shown in a plan view. The detachment structure 61 of the present example is fabricated by processing a plate-like member into a predetermined shape and bending a portion of the plate-like member, and has a base portion 62 and a pair of projection pieces 63. The base portion 62 is formed to extend in one direction. The pair of projection pieces 63 projects from both ends of the base portion 62 toward one side of the base portion 62. A semicircular recess portion 64 is formed in the portion of the base portion 62 located between the pair of projection pieces 63. In the brush discarder 220 of Fig. 1, the detachment structure 61 is arranged such that the base portion 62 and the pair of projection pieces 63 are parallel or substantially parallel to a horizontal plane and the pair of projection pieces 63 are directed in the + X direction in plan view.

In a case in which the brush device 50 is detached from the brush device connecting portion 400, the brush device 50 is arranged below the brush discarder 60. More specifically, as shown in the middle field of Fig. 13, the flange portion 55 of the brush device 50 is arranged below the base portion 62 of the detachment structure 61. The brush device connecting portion 400 is arranged in the recess portion 64 of the detachment structure 61.

Thereafter, as shown in the lower field of Fig. 13, the brush device connecting portion 400 is lifted up with a force equal to or larger than a certain force. At this time, inside of the first cylindrical portion 421 of the brush device connecting portion 400, the first cylindrical portion 421 and the connected column 56 move relative to each other against an engaging force exerted between the three steel balls 490, and the first groove portion 56a and the second groove portion 56b of the connected column 56. Thus, the brush device 50 is detached from the brush device connecting portion 400.

### 6. Control System of Substrate Cleaning Device 1

A control system of the substrate cleaning device 1 will be described together with the configuration of the controller 900 of Fig. 1. Fig. 14 is a block diagram showing the configuration of the control system of the substrate cleaning device 1 of Fig. 1. As shown in Fig. 14, the controller 900 includes a CPU (Central Processing Unit) 901, a RAM (Random Access Memory) 902, a ROM (Read Only Memory) 903 and a storage device 904. The RAM 902 is used as a work area for the CPU 901. A system program is stored in the ROM 903. The storage device 904 includes a storage medium such as a hard disc or a semiconductor memory, and stores a substrate cleaning program for executing the brush cleaning process and the spray cleaning process for the substrate W, a replacement process program for executing the process of replacing the brush device 50, and the like. Further, the storage device 904 stores the above-mentioned brush path information.

The substrate cleaning program and the replacement processing program may be provided while being stored in a recording medium such as a CD-ROM 909 and may be installed in the ROM 903 or the storage device 904. Alternatively, each of the substrate cleaning program and the replacement processing program may be distributed from a server outside of the substrate cleaning device 1 through a communication network, and may be installed in the ROM 903 or the storage device 904.

The CPU 901 executes the substrate cleaning program and the replacement processing program, so that the work of each component of the substrate cleaning device 1 is controlled. Specifically, the controller 900 controls the substrate holding driver 13. Thus, the controller 900 causes the substrate holding device 10 to hold the substrate W carried into the substrate cleaning device 1 by changing the state of the plurality of holding pins 12 from the release state to the holding state. Further, the controller 900 changes the state of the plurality of holding pins 12 from the holding state to the release state in order to carry the substrate W out of the substrate cleaning device 1. Further, the controller 900 controls the substrate rotation driver 14. Further, the controller 900 rotates the substrate W held by the substrate holding device 10 at a preset speed.

Further, the controller 900 controls the cup lifting-lowering driver 22. Thus, the controller 900 moves the cup body 21 of Fig. 1 between the cup upper position and the cup lower position during the brush cleaning process for the substrate W and during the spray cleaning process for the substrate W.

Further, the controller 900 controls the liquid driver 314 and the liquid supply system 315. Thus, in a case in which the brush cleaning process for the substrate W is executed, the controller 900 directs the tip portion of the arm 312 of Fig. 1 toward the substrate W and supplies a cleaning liquid to the liquid nozzle 313. Further, in a case in which the brush cleaning process for the substrate W is not executed, the controller 900 directs the tip portion of the arm 312 toward the space located sidewardly (in the - X direction) of the substrate holding device 10 and stops the supply of the cleaning liquid to the liquid nozzle 313.

Further, the controller 900 controls the gas driver 324 and the gas supply system 325. Thus, in a case in which the substrate W is dried, the controller 900 directs the tip portion of the arm 322 of Fig. 1 toward the substrate W and supplies a gas to the gas nozzle 323. Further, in a case in which the substrate W is not dried, the controller 900 directs the tip portion of the arm 322 toward the space located sidewardly (in the - Y direction) of the substrate holding device 10 and stops the supply of the gas to the gas nozzle 323.

Further, the controller 900 controls the spray driver 334 and the fluid supply system 335. Thus, in a case in which the spray cleaning process for the substrate W is executed, the controller 900 moves the tip portion of the arm 332 of Fig. 1 on the substrate W and supplies a cleaning liquid and a gas to the spray nozzle 333. Further, in a case in which the spray cleaning for the substrate W is not executed, the controller 900 directs the tip portion of the arm 332 toward the space located sidewardly (in the + X direction) of the substrate holding device 10 and stops the supply of a cleaning liquid and a gas to the spray nozzle 333.

Further, the controller 900 controls the pressing rotation driver 112. Thus, the controller 900 presses the brush device 50 against the upper surface of the substrate W with a preset pressing force during the brush cleaning process for the substrate W. Further, the controller 900 causes the brush device 50 to spin during the brush cleaning process for the substrate W.

Further, the controller 900 controls the arm rotation driver 141. Specifically, the controller 900 rotates the rotation shaft 120 based on the outputs of the encoder of the arm rotation driver 141 and the origin detection sensor associated with the arm rotation driver 141. This changes the posture of the brush arm 110.

Further, the controller 900 controls the arm movement driver 142. Specifically, the controller 900 moves the arm supporter 140 in the X direction based on the outputs of the encoder of the arm movement driver 142 and the origin detection sensor associated with the arm movement driver 142. This changes the position of the brush arm 110 in the X direction.

Further, the controller 900 controls the arm lifting-lowering driver 143. Specifically, the controller 900 moves the rotation shaft 120 in the Z direction based on the outputs of the encoder of the arm lifting-lowering driver 143 and the origin detection sensor associated with the arm lifting-lowering driver 143. This changes the height position of the brush arm 110.

The arm rotation driver 141, the arm movement driver 142 and the arm lifting-lowering driver 143 are controlled based on brush path information in addition to the outputs of the various encoders and the origin detection sensor, described above, during the brush cleaning process for the substrate W, for example. Thus, the brush device 50 moves in the chamber CH along the path represented by the brush path information, and the substrate W is cleaned.

Further, the controller 900 controls the liquid circulation system 239. Thus, the controller 900 adjusts an amount of processing liquid to be supplied to the storage tank and an amount of processing liquid to be discharged from the storage tank such that a predetermined amount of the processing liquid is kept stored in the storage tank of the brush storage device 230.

Further, the controller 900 acquires the number of brush devices 50 stored in the storage state detector 240 based on the output of the storage state detector 240. Further, the controller 900 acquires a position where the brush device 50 is stored in the storage tank of the storage state detector 240. Then, the controller 900 determines a position of the brush device 50 to be replaced in the next process of replacing the brush 51. That is, the controller 900 sets a position of the brush device 50 to be newly held by the brush holder 111 during the next process of replacing the brush 51.

Further, during the process of replacing the brush 51, the controller 900 acquires the shape of the replaced brush 51 of the brush device 50 based on the output of the brush shape detector 250. Further, the controller 900 suitably corrects the brush path information stored in the storage device 904 based on the acquired shape.

As shown in Fig. 14, the substrate cleaning device 1 further includes an operation unit 600. The operation unit 600 includes a keyboard and a pointing device, and is configured to be operable by a user. The user can provide an instruction for executing the brush cleaning process and an instruction for executing the spray cleaning process, for example, to the controller 900 by operating the operation unit 600. Further, the user can provide an instruction for executing the process of replacing the brush device 50 to the controller 900. Further, the user can provide brush path information to the controller 900 by operating the operation unit 600.

The controller 900 accepts various instructions or various information pieces from the operation unit 600. Further, the controller 900 controls each component of the substrate cleaning device 1 according to an accepted instruction or an accepted designation.

### 7. Effects

(a) In the above-mentioned substrate cleaning device 1, the brush holder 111 of the brush arm device 100 holds a brush device 50 by connecting the brush device connecting portion 400 to a connected column 56 of the brush device 50. During the brush cleaning process for a substrate W, the brush holder 111 is moved such that a brush 51 comes into contact with the substrate W held by the substrate holding device 10 with one brush device 50 held by the brush holder 111. Thus, the substrate W is cleaned. At this time, in the brush storage device 230, another brush device 50 is stored temporarily.

When being contaminated or deteriorated to such an extent that replacement is required, the one brush device 50 is detached from the brush holder 111. Thereafter, the brush holder 111 is moved to the brush storage device 230, and the brush device connecting portion 400 of the brush holder 111 is connected to a connected column 56 of another brush device 50 stored in the brush storage device 230. In this manner, the brush device 50 held by the brush holder 111 is replaced with the other brush device 50.

The brush arm 110 is moved and rotated in the chamber CH by the arm rotation driver 141 and the arm movement driver 142. Thus, the brush holder 111 is movable in two different directions in plan view. In this case, the movable range of the brush holder 111 in plan view is enlarged as compared with a case in which the brush arm device 100 includes only one of the arm rotation driver 141 and the arm movement driver 142. This improves a degree of freedom of the layout of the substrate holding device 10, the waiting pod 210, the brush discarder 220 and the brush storage device 230.

Therefore, the waiting pod 210, the brush discarder 220 and the brush storage device 230 can be arranged in desired portions in the chamber CH. That is, the arrangement of the substrate holding device 10, the waiting pod 210, the brush discarder 220 and the brush storage device 230 in the chamber CH can be determined according to a purpose such as miniaturization of the substrate cleaning device 1 or improvement of throughput.

In the example of Fig. 1, because the waiting pod 210, the brush discarder 220 and the brush storage device 230 are arranged on the virtual straight line L2 between the substrate holding device 10 and the first sidewall SW1 in the Y direction, the chamber CH in the Y direction can be miniaturized.

Further, in this case, because a plurality of constituent elements for the brush cleaning process by the brush device 50 can be compactly arranged in the substrate cleaning device 1, it is possible to add an additional function to the substrate cleaning device 1 while suppressing an increase in size of the substrate cleaning device 1.

(b) In the above-mentioned substrate cleaning device 1, the brush storage device 230 and the brush discarder 220 are adjacent to each other. This can reduce a period of time required for the brush holder 111 to hold another brush device 50 after one brush device 50 held by the brush holder 111 is detached in the brush discarder 220. That is, it is possible to shorten a period of time required for replacing the brush device 50 with respect to the brush holder 111.

(c) In the above-mentioned substrate cleaning device 1, the brush holder 111 of the brush arm 110 is rotated about the rotation shaft 120 by the arm rotation driver 141. Further, the brush holder 111 is moved in the X direction by the arm movement driver 142. That is, the brush holder 111 is movable in two different directions in a horizontal plane.

Here, the configuration for linearly moving the brush holder 111 in one direction in a horizontal plane is likely to have a large occupied space required in the horizontal plane as in the guide rail 130 of Fig. 1. In contrast, the configuration for rotating the brush holder 111 in a horizontal plane is likely to have a smaller occupied space required in the horizontal plane as in the rotation shaft 120 of Fig. 1.

The substrate cleaning device 1 of Fig. 1 includes the rotation shaft 120 and the arm rotation driver 141 as the configuration for moving the brush holder 111 in a horizontal plane. Thus, the configuration for moving the brush holder 111 is miniaturized in a horizontal plane.

### 8. Substrate Processing Apparatus Including Substrate Cleaning Device 1

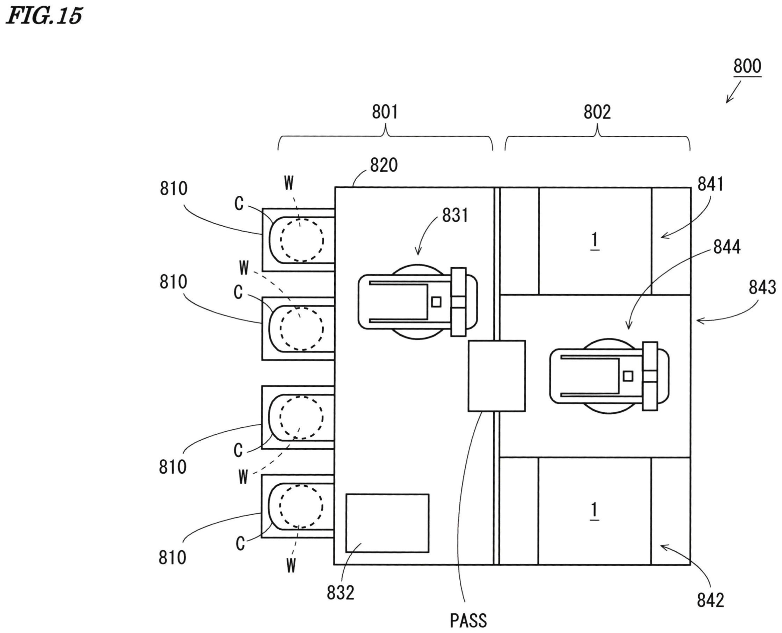

Fig. 15 is a schematic plan view showing one example of the substrate processing apparatus including the substrate cleaning device 1 of Fig. 1. As shown in Fig. 15, the substrate processing apparatus 800 of the present example has an indexer block 801 and a processing block 802. The indexer block 801 and the processing block 802 are provided to be adjacent to each other.

The indexer block 801 includes a plurality (four in the present example) of carrier platforms 810 and a transport section 820. The plurality of carrier platforms 810 are connected to the transport section 820 and arranged in a row and at intervals. On each carrier platform 810, a carrier C for storing a plurality of substrates W is placed.

In the transport section 820, an indexer robot 831 and a control device 832 are provided. The indexer robot 831 includes a plurality (four, for example) of hands, and is configured to be capable of holding and transporting a substrate W. The control device 832 includes a CPU and a memory, or a microcomputer, and controls each constituent element of the substrate processing apparatus 800.

The processing block 802 includes cleaning sections 841, 842 and a transport section 843. The cleaning section 841, the transport section 843 and the cleaning section 842 are arranged in this order to be adjacent to the transport section 820. In each of the cleaning sections 841, 842, a plurality (four, for example) of substrate cleaning devices 1 are arranged in a stack. These substrate cleaning devices 1 are the substrate cleaning devices 1 of Fig. 1. That is, in the substrate processing apparatus 800 of Fig. 15, the substrate cleaning device 1 of Fig. 1 is provided as one processing unit forming the substrate processing apparatus 800.

A main robot 844 is provided in the transport section 843. The main robot 844 includes a plurality (four, for example) of hands, and is configured to be capable of holding and transporting a substrate W.

A plurality of substrate platforms PASS for receiving and transferring substrates W between the indexer robot 831 and the main robot 844 are stacked between the indexer block 801 and the processing block 802.

In the substrate processing apparatus 800, the indexer robot 831 takes out an unprocessed substrate W from any one of the plurality of carriers C placed on the plurality of carrier platforms 810. Further, the indexer robot 831 places the unprocessed substrate W on any one of the plurality of substrate platforms PASS. Further, the indexer robot 831 receives a processed substrate W placed on any one of the plurality of substrate platforms PASS and accommodates the substrate W in an empty carrier C.

The main robot 844 receives a plurality of respective unprocessed substrates W placed on the plurality of respective substrate platforms PASS. Further, the main robot 844 carries the plurality of unprocessed substrates W into the plurality of substrate cleaning devices 1 in the cleaning sections 841, 842. Further, the main robot 844 carries out the plurality of respective processed substrate W in the plurality of respective substrate cleaning devices 1. Further, the main robot 844 places a processed substrate W on any one of the plurality of substrate platforms PASS.

Each substrate cleaning device 1 in the cleaning sections 841, 842 includes the arm rotation driver 141, the arm movement driver 142 and the arm lifting-lowering driver 143 as the configurations for moving the brush holder 111 in the chamber CH. This enlarges the range in which the brush holder 111 can be moved in the chamber CH. In this case, the waiting pod 210, the brush discarder 220 and the brush storage device 230 can be arranged in desired portions in the chamber CH. Therefore, it is possible to miniaturize the substrate cleaning device 1 and miniaturize the substrate processing apparatus 800. Alternatively, it is also possible to provide an additional function to the substrate cleaning device 1 while suppressing an increase in size of each substrate cleaning device 1.

### 9. Other Embodiments

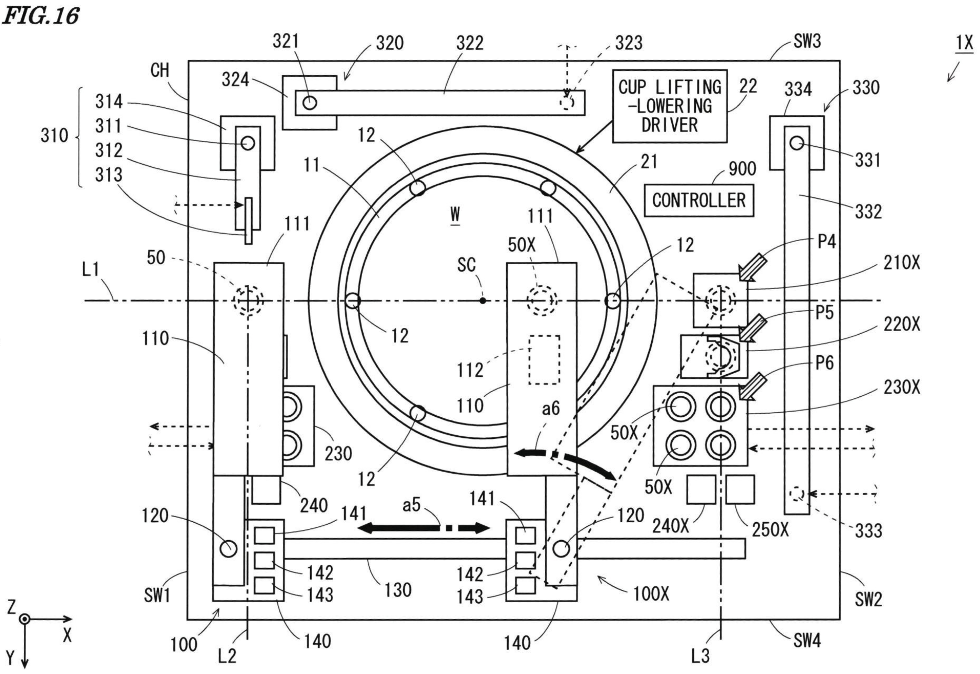

(a) Fig. 16 is a schematic plan view of a substrate cleaning device according to another embodiment. Differences of the substrate cleaning device 1X of Fig. 16 from the substrate cleaning device 1 of Fig. 1 will be described. As shown in Fig. 16, the substrate cleaning device 1X of the present example further includes a brush arm device 100X, a waiting pod 210X, a brush discarder 220X, a brush storage device 230X, a storage state detector 240X and a brush shape detector 250X in addition to the configurations of the substrate cleaning device 1 of Fig. 1. These constituent elements (100X, 210X, 220X, 230X, 240X, 250X) are provided in the chamber CH.

The brush arm device 100X has basically the same configuration as the brush arm device 100. An arm supporter 140 of the brush arm device 100X is provided on a guide rail 130, and supports a rotation shaft 120 such that the rotation shaft 120 is movable in the Z direction. An arm rotation driver 141, an arm movement driver 142 and an arm lifting-lowering driver 143 are built in the arm supporter 140.

In the brush arm device 100X, the arm rotation driver 141 rotates the rotation shaft 120 based on the control of a controller 900. Thus, a brush arm 110 provided at the rotation shaft 120 rotates about the rotation shaft 120 (see the thick one-dot and dash arrow a6 of Fig. 16). Further, in the brush arm device 100X, the arm movement driver 142 moves the arm supporter 140 in the X direction based on the control of the controller 900 (see the thick one-dot and dash arrow a5 of Fig. 16). Further, in the brush arm device 100X, the arm lifting-lowering driver 143 moves the rotation shaft 120 in the Z direction based on the control of the controller 900.

Similarly to the brush arm 110 of the brush arm device 100, the brush arm 110 of the brush arm device 100X has a built-in pressing rotation driver 112. The brush holder 111 of the brush arm device 100X is configured to be capable of holding and detaching a brush device 50X. Here, a brush of the brush device 50X may be the same as or different from the brush 51 of the brush device 50 of Fig. 1. In a case in which the brush 51 of the brush device 50X of the present example is different from the brush 51 of the brush device 50 of Fig. 1, one brush 51 may be a sponge and the other brush 51 may be a sponge in which abrasive grains are dispersed, for example.

The waiting pod 210X, the brush discarder 220X and the brush storage device 230X correspond to the brush arm device 100X, and have the same configurations as the waiting pod 210, the brush discarder 220 and the brush storage device 230 of Fig. 1.

Here, in the substrate cleaning device 1 of Fig. 16, virtual straight lines L1, L2 are defined similarly to the substrate cleaning device 1 of Fig. 1. Further, in the substrate cleaning device 1 of Fig. 16, a straight line that is orthogonal to the virtual straight line L1 in plan view, extends in the Y direction, and is located between a substrate holding device 10 and a second sidewall SW2 is defined as a virtual straight line L3.

The waiting pod 210X, the brush discarder 220X and the brush storage device 230X are provided at positions symmetrical to the waiting pod 210, the brush discarder 220 and the brush storage device 230 with respect to a vertical plane including a rotation center SC of a spin base 11 and being orthogonal to the virtual straight line L1. Thus, between the substrate holding device 10 and the second sidewall SW2 in the X direction, the waiting pod 210X, the brush discarder 220X and the brush storage device 230X are arranged in this order in the + Y direction on the virtual straight line L3.

With such a configuration, when the brush device 50X held by the brush arm device 100X is waiting, the brush device 50X is accommodated and cleaned in the waiting pod 210X. Further, in the brush discarder 220X, the brush device 50X is detached from the brush arm device 100X during a process of replacing the brush device 50X. Further, in the brush storage device 230X, one or a plurality of unused brush devices 50X are stored in a storage tank.

In the present example, as indicated by the hatched arrow in Fig. 16, a waiting position P4 is set at a position overlapping with the waiting pod 210X in plan view. Further, a detachment position P5 is set at a position overlapping with the brush discarder 220X in plan view. Further, an attachment position P6 is set at a position overlapping with the brush storage device 230X in plan view.

Therefore, the brush holder 111 of the brush arm device 100X moves between a position above the substrate W held by the substrate holding device 10 and the waiting position P4, and moves in the Z direction, whereby a brush cleaning process for the substrate W is executed by the brush device 50X. Further, the brush holder 111 of the brush arm device 100X moves to the waiting position P4, the detachment position P5 and the attachment position P6, and moves in the Z direction, whereby a process of replacing the brush device 50X is executed.

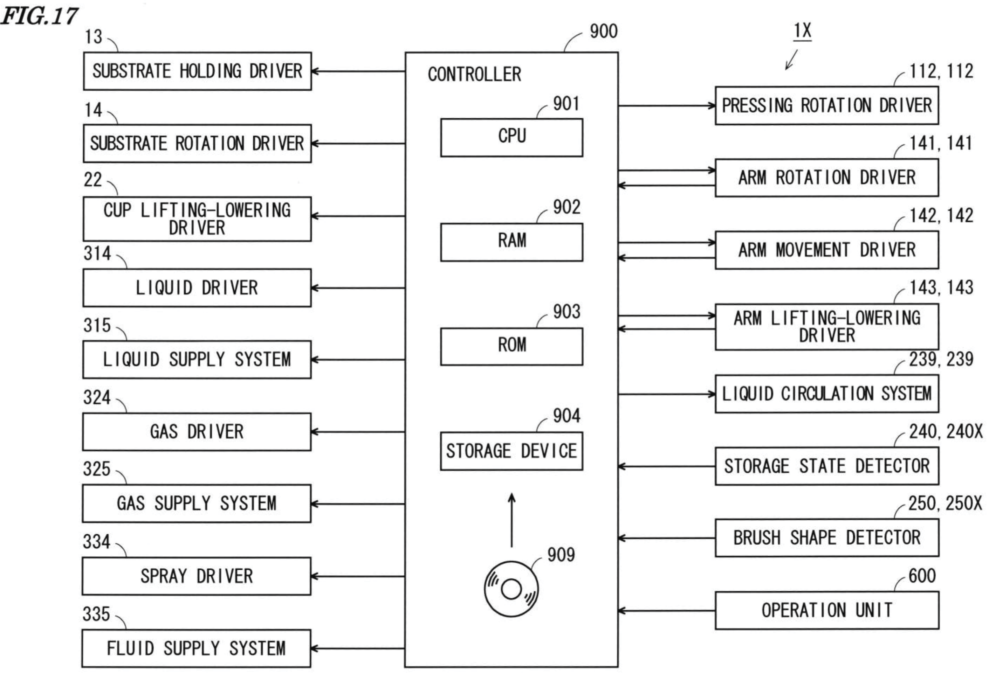

Fig. 17 is a block diagram showing the configuration of a control system of the substrate cleaning device 1X of Fig. 16. The control system of Fig. 17 is different from the control system of Fig. 14 in that the controller 900 controls the constituent elements (112, 112, 141, 141, 142, 142, 143, 143, 239, 239, 240, 240X, 250, 250X) corresponding to the two types of brush devices 50, 50X.

In the substrate cleaning device 1X of Fig. 16, as described above, the two brush arm devices 100, 100X respectively corresponding to the two types of brush devices 50, 50X are provided in one chamber CH. Thus, in the one chamber CH, two types of brush cleaning processes using the two types of brush devices 50, 50X can be executed.

Further, each of the brush arm devices 100, 100X includes the arm rotation driver 141 and the arm movement driver 142. In this case, the movable range of each brush holder 111 in plan view is enlarged. Thus, on the virtual straight lines L2, L3 arranged in the X direction with the substrate holding device 10 interposed therebetween, a plurality of constituent elements (210, 220, 230) corresponding to the brush device 50 can be arranged, and a plurality of constituent elements (210X, 220X, 230X) corresponding to the brush device 50X can be arranged.

As a result, it is possible to provide two types of cleaning functions using brushes and a brush replacement function in one substrate cleaning device 1 while suppressing an increase in size of the substrate cleaning device 1.

(b) While the substrate cleaning device 1 according to the above-mentioned embodiment is configured such that the brush holder 111 is movable in the X direction and movable in a rotation direction about the rotation shaft 120, the present disclosure is not limited to this. In the present disclosure, the brush holder 111 is only required to move in two different directions in plan view. In this case, the two directions do not have to be the X direction and the rotation direction about the rotation shaft 120.

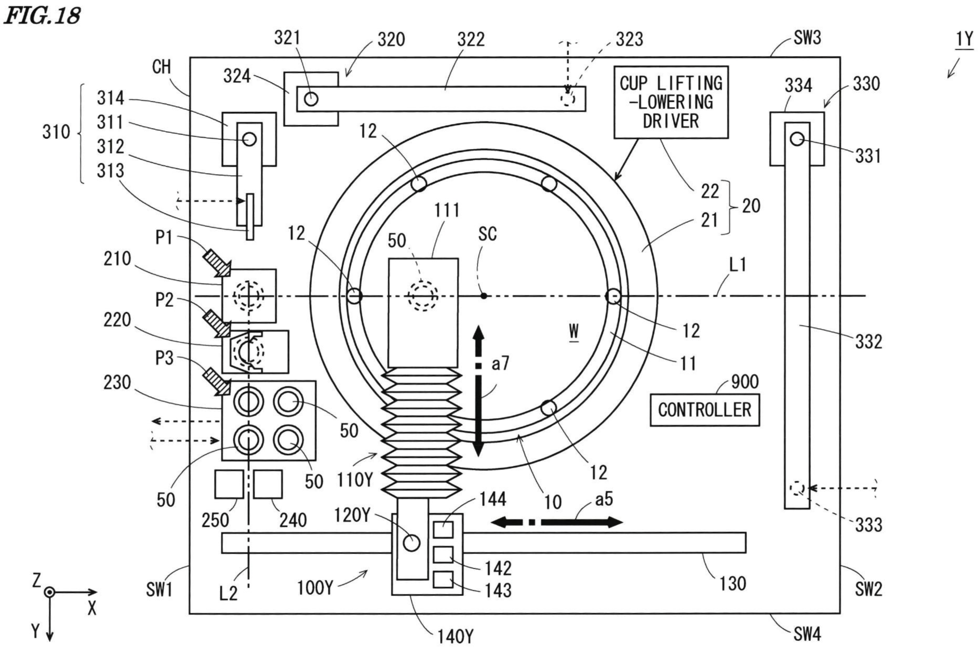

Fig. 18 is a schematic plan view of a substrate cleaning device according to yet another embodiment. The substrate cleaning device 1Y of Fig. 18 includes a brush arm device 100Y instead of the brush arm device 100 of Fig. 1. The brush arm device 100Y includes an arm supporter 140Y, a shaft member 120Y and a brush arm 110Y.

The arm supporter 140Y is provided so as to be movable in the X direction on a guide rail 130. The shaft member 120Y extends in the Z direction, and is supported by the arm supporter 140Y so as to be non-rotatable and movable in the Z direction. The brush arm 110Y is provided so as to extend in the - Y direction from the upper end portion of the shaft member 120Y. The tip portion of the brush arm 110Y is configured to be capable of holding and detaching a brush device 50 as a brush holder 111.

Here, a portion of the brush arm 110Y is configured to be extendable and contractible in the Y direction. Further, an arm movement driver 142, an arm lifting-lowering driver 143 and an arm extending-contracting driver 144 are built in the arm supporter 140. The arm movement driver 142 and the arm lifting-lowering driver 143 built in the arm supporter 140Y respectively have the same configurations as the arm movement driver 142 and the arm lifting-lowering driver 143 built in the arm supporter 140 of Fig. 1. The arm movement driver 142 and the arm lifting-lowering driver 143 built in the arm supporter 140Y work respectively similarly to the arm movement driver 142 and the arm lifting-lowering driver 143 built in the arm supporter 140 of Fig. 1.

The arm extending-contracting driver 144 includes an actuator such as a motor or an air cylinder, and extends and contracts the brush arm 110Y. That is, the arm extending-contracting driver 144 moves the brush holder 111 of the brush arm 110Y in the Y direction based on the control of a controller 900 (see the thick one-dot and dash arrow a7 of Fig. 18).

As described above, in the substrate cleaning device 1Y of Fig. 18, the brush holder 111 is moved in the X direction and the Y direction different from each other in a chamber CH by the arm movement driver 142 and the arm extending-contracting driver 144. This improves a degree of freedom of the layout of the substrate holding device 10, a waiting pod 210, a brush discarder 220 and a brush storage device 230 in the chamber CH.

In addition to the above-mentioned example of Fig. 18, the two directions in which the brush holder 111 moves in plan view may be one rotation direction about one vertical axis and another rotation direction about another vertical axis. For example, the brush arm device 100 may be configured such that the arm supporter 140 rotates about one rotation axis extending in the Z direction and the brush arm 110 rotates about another rotation axis supported by the arm supporter 140. That is, the brush arm device 100 may be configured similarly to an articulated arm having two rotation axes in a joint portion.

(c) In the substrate cleaning device 1 according to the above-mentioned embodiment, the gas supply device 320 does not have to be provided. Further, the spray device 330 does not have to be provided in the substrate cleaning device 1. In these cases, the configuration of the substrate cleaning device 1 is simplified.

(d) The substrate cleaning device 1 according to the above-mentioned embodiment has the liquid supply device 310, the gas supply device 320, the spray device 330 and the brush arm device 100. Thus, in the substrate cleaning device 1, a cleaning process for the substrate W can be executed using only the liquid supply device 310. Further, a spray cleaning process for the substrate W can be executed using only the spray device 330. Further, a brush cleaning process for the substrate W can be executed using the liquid supply device 310 and the brush arm device 100.

Therefore, depending on the type of the substrate W or the purpose of cleaning the substrate W, a brush cleaning process does not necessarily need to be executed in the substrate cleaning device 1. For example, in the substrate cleaning device 1, only a spray cleaning process by the spray device 330 may be executed. Alternatively, only a cleaning process by the liquid supply device 310 may be executed. In this manner, a method of cleaning the substrate W in the substrate cleaning device 1 does not necessarily include a brush cleaning process.

(e) While the substrate holding device 10 has a so-called mechanical chuck-type configuration that holds a substrate W by abutment of the plurality of holding pins 12 against the outer peripheral end of the substrate W in the substrate cleaning device 1 according to the above-mentioned embodiment, the present disclosure is not limited to this. The substrate holding device 10 may have a suction-type configuration that holds the lower-surface center portion of a substrate W by suction.

### 10. Correspondences Between Constituent Elements in Claims and Parts in Preferred Embodiments

In the following paragraphs, non-limiting examples of correspondences between various elements recited in the claims below and those described above with respect to various preferred embodiments of the present disclosure are explained. As each of various elements recited in the claims, various other elements having configurations or functions described in the claims can be also used.

In the above-mentioned embodiment, the substrate holding device 10 is an example of a substrate holder, the connected column 56 of the brush device 50 is an example of a first connected portion, the plurality of brush devices 50 are examples of a first cleaner and a second cleaner, the brush device connecting portion 400 of the brush arm device 100 is an example of a first connecting portion, and the brush holder 111 of the brush arm device 100 is an example of a first cleaner holder.

Further, the brush storage device 230 is an example of a first cleaner storage, the arm rotation driver 141, the arm movement driver 142 and the arm lifting-lowering driver 143 of the brush arm device 100, and the arm movement driver 142, the arm lifting-lowering driver 143 and the arm extending-contracting driver 144 of the brush arm device 100Y are examples of a first holder movement device, the controller 900 is an example of a controller, the direction (X direction) of the thick one-dot and dash arrow a6 of Figs. 1 and 18 is an example of a first direction and a third direction, the direction (Y direction) of the thick one-dot and dash arrow a4 of Fig. 1 and the thick one-dot and dash arrow a7 of Fig. 18 is an example of a second direction, and the direction (X direction) of the thick one-dot and dash arrow a5 of Fig. 16 is an example of a third direction.

Further, the arm movement driver 142 of each of the brush arm device 100 and the brush arm device 100Y is an example of a first driver, the arm rotation driver 141 of the brush arm device 100 and the arm extending-contracting driver 144 of the brush arm device 100Y are examples of a second driver, and the substrate cleaning device 1 and the substrate processing apparatus 800 are examples of a substrate processing apparatus.

Further, the virtual straight line L1 is an example of a first virtual straight line, the center axis of the rotation shaft 120 is an example of an axis intersecting with the first direction, the waiting pod 210 is an example of a waiting pod, the brush discarder 220 is an example of a detacher, the virtual straight line L2 is an example of a second virtual straight line, the connected column 56 of the brush device 50X is an example of a second connected portion, the plurality of brush devices 50X are examples of a third cleaner and a fourth cleaner, the brush device connecting portion 400 of the brush arm device 100X is an example of a second connecting portion, and the brush holder 111 of the brush arm device 100X is an example of a second cleaner holder.

Further, the brush storage device 230X is an example of a second cleaner holder, the arm rotation driver 141, the arm movement driver 142 and the arm lifting-lowering driver 143 of the brush arm device 100X are examples of a second holder movement device, the direction of the thick one-dot and dash arrow a6 of Fig. 16 is an example of a fourth direction, the arm movement driver 142 of the brush arm device 100X is an example of a third driver, the arm rotation driver 141 of the brush arm device 100X is an example of a fourth driver, the virtual straight line L2 is an example of a second virtual line, and the virtual straight line L3 is an example of a third virtual line.

### 11. Overview of Embodiments

(Item 1) A substrate processing apparatus according to item 1 includes a substrate holder that holds a substrate, a first cleaner and a second cleaner that respectively have first connected portions, a first cleaner holder that has a first connecting portion, the first connecting portion being attachable to and detachable from the first connected portions of the first cleaner and the second cleaner, a first cleaner storage that is provided outside of the substrate holder and temporarily stores the second cleaner, a first holder movement device that moves the first cleaner holder, and a controller that controls the first holder movement device with the first cleaner holder holding the first cleaner to clean the substrate held by the substrate holder, and after the first cleaner used for cleaning the substrate is detached from the first cleaner holder, controls the first holder movement device to connect the first connecting portion of the first cleaner holder to the first connected portion of the second cleaner temporarily stored in the first cleaner storage, wherein the first holder movement device includes a first driver and a second driver that respectively move the first cleaner holder in a first direction and a second direction that are different from each other.

In the substrate processing apparatus, the first cleaner holder holds each of the first cleaner and the second cleaner by connecting the first connecting portion to the first connected portion. The first cleaner holder is moved such that the cleaning surface of the first cleaner comes into contact with the substrate held by the substrate holder with the first cleaner held by the first cleaner holder. Thus, the substrate is cleaned. At this time, the second cleaner is temporarily stored in the first cleaner storage.

When the first cleaner is contaminated or deteriorated to such an extent that replacement is required, the first cleaner is detached from the first cleaner holder. Thereafter, the first cleaner holder is moved to the first cleaner storage, and the first connecting portion of the first cleaner holder is connected to the first connected portion of the second cleaner stored in the first cleaner storage. In this manner, the cleaner held by the first cleaner holder is replaced with a new cleaner.

The first holder movement device includes the first driver and the second driver. In this case, the movable range of the first cleaner holder in a plane parallel to the first direction and the second direction is enlarged as compared with a case in which the first holder movement device includes only one of the first driver and the second driver. This improves a degree of freedom of layout of a plurality of constituent elements including the substrate holder and the first cleaner storage.

(Item 2) The substrate processing apparatus according to item 1, wherein the first direction may extend along a first virtual line extending linearly in plan view, and the second direction may be a rotation direction about an axis intersecting with the first direction.

Here, the orientations of the first cleaner holder and one cleaner in a plane parallel to the first direction and the second direction are referred to as postures. In this case, with the first driver, it is possible to, with the first cleaner holder holding the one cleaner, move the first cleaner holder in parallel with the first virtual line while maintaining the postures of the first cleaner holder and the one cleaner. Further, with the second driver, it is possible to, with the first cleaner holder holding the one cleaner, rotate the first cleaner holder about an axis intersecting with the first direction. At this time, the postures of the first cleaner holder and the one cleaner are changed with the rotation.

(Item 3) The substrate processing apparatus according to item 1 or 2, may further include a waiting pod that is provided outside of the substrate holder and is configured to be accommodate the first cleaner and the second cleaner held by the first cleaner holder, wherein the first holder movement device may further move the first cleaner holder to the waiting pod.

In this case, the first cleaner or the second cleaner held by the first cleaner holder can be accommodated in the waiting pod. Further, because the first holder movement device includes the first driver and the second driver, it is not necessary to arrange the substrate holder, the first cleaner storage and the waiting pod in one direction.

(Item 4) The substrate processing apparatus according to claim 1, may further include a detacher that is provided outside of the substrate holder and detaches the first cleaner and the second cleaner held by the first cleaner holder from the first cleaner holder, and the first holder movement device may further move the first cleaner holder to the detacher.

In this case, in the detacher, the first cleaner or the second cleaner held by the first cleaner holder can be detached from the first cleaner holder. Further, because the first holder movement device includes the first driver and the second driver, it is not necessary to arrange the substrate holder, the first cleaner storage and the detacher in one direction.

(Item 5) The substrate processing apparatus according to item 4, wherein the first cleaner storage and the detacher may be arranged to be adjacent to each other in plan view.

In this case, because the first cleaner storage and the detacher are adjacent to each other, it is possible to shorten a required period of time from the time when the first cleaner held by the first cleaner holder is detached from the first cleaner holder to the time when the first connecting portion of the first cleaner holder is connected to the first connected portion of the second cleaner. That is, it is possible to shorten a period of time required for replacing the cleaner with respect to the first cleaner holder.

(Item 6) The substrate processing apparatus according to item 2, may further include a waiting pod that is provided outside of the substrate holder and is configured to accommodate the first cleaner and the second cleaner held by the first cleaner holder, and a detacher that is provided outside of the substrate holder and detaches the first cleaner and the second cleaner held by the first cleaner holder from the first cleaner holder, wherein the first holder movement device may further move the first cleaner holder to the waiting pod, the substrate holder may overlap with the first virtual line in plan view, the first cleaner holder, the waiting pod and the detacher may overlap with a second virtual line intersecting with the first virtual line in plan view, and at least portions of the first cleaner storage, the waiting pod and the detacher may overlap with the first virtual line in plan view.

In plan view, the substrate is larger than the cleaner. Since holding the substrate, the substrate holder occupies a large space in a horizontal plane as compared to the first cleaner storage in which the cleaner is stored, etc, the waiting pod and the detacher.

With the above-mentioned configuration, the first cleaner storage, the waiting pod and the detacher are compactly arranged close to one side of the substrate holder in plan view. Therefore, the substrate processing apparatus is miniaturized.

(Item 7) The substrate processing apparatus according to item 2, may further include a third cleaner and a fourth cleaner that respectively has second connected portions, a second cleaner holder that has a second connecting portion that is attachable to and detachable from the second connected portions of the third cleaner and the fourth cleaner, a second cleaner storage that is provided outside of the substrate holder, and temporarily stores the fourth cleaner, and a second holder movement device that moves the second cleaner holder, wherein the controller controls the second holder movement device with the second cleaner holder holding the third cleaner to clean the substrate held by the substrate holder, and after the third cleaner used for cleaning the substrate is detached from the second cleaner holder, controls the second holder movement device to connect the second connecting portion of the second cleaner holder to the second connected portion of the fourth cleaner temporarily stored in the second cleaner storage, and the second holder movement device includes a third driver and a fourth driver that respectively move the second cleaner holder in a third direction and a fourth direction that are different from each other.

In this case, the second cleaner holder holds each of the third cleaner and the fourth cleaner by connecting the second connecting portion to the second connected portion. The second cleaner holder is moved such that the cleaning surface of the third cleaner comes into contact with the substrate held by the substrate holder with the third cleaner held by the second cleaner holder. Thus, the substrate is cleaned. At this time, the fourth cleaner is temporarily stored in the second cleaner storage.

When the third cleaner is contaminated or deteriorated to such an extent that replacement is required, the third cleaner is detached from the second cleaner holder. Thereafter, the second cleaner holder is moved to the second cleaner storage, and the second connecting portion of the second cleaner holder is connected to the second connected portion of the fourth cleaner stored in the second cleaner storage. In this manner, the cleaner held by the second cleaner holder is replaced with a new cleaner.

The second holder movement device includes the third driver and the fourth driver. In this case, the movable range of the second cleaner holder in a plane parallel to the third direction and the fourth direction is enlarged as compared with a case in which the second holder movement device includes only one of the third driver and the fourth driver. This improves a degree of freedom of layout of a plurality of constituent elements including the substrate holder and the second cleaner storage.

(Item 8) The substrate processing apparatus according to item 7, wherein the third direction may be a same direction as the first direction, the substrate holder may overlap with the first virtual line in plan view, the first cleaner storage may overlap with a second virtual line intersecting with the first virtual line in plan view, the second cleaner storage may overlap with a third virtual line that intersects with the first virtual line and is parallel to the second virtual line in plan view, and the substrate holder may be located between the second virtual line and the third virtual line in plan view.

In plan view, the substrate is larger than the cleaner. Since holding the substrate, the substrate holder occupies a large space in a horizontal plane as compared to the first cleaner storage and the second cleaner storage in which cleaners are stored, etc.

With the above-mentioned configuration, the first cleaner storage and the members associated with the first cleaner storage are compactly arranged close to one side of the substrate holder in plan view. Further, the second cleaner storage and the members associated with the second cleaner storage are compactly arranged close to the other side of the substrate holder. Therefore, it is possible to provide two types of cleaning functions and a brush replacement function in one substrate processing apparatus while suppressing an increase in size of the substrate processing apparatus.

While preferred embodiments of the present disclosure have been described above, it is to be understood that variations and modifications will be apparent to those skilled in the art without departing the scope and spirit of the present disclosure. The scope of the present disclosure, therefore, is to be determined solely by the following claims.

## Claims

1. A substrate processing apparatus comprising:
a substrate holder that holds a substrate;
a first cleaner and a second cleaner that respectively have first connected portions;
a first cleaner holder that has a first connecting portion, the first connecting portion being attachable to and detachable from the first connected portions of the first cleaner and the second cleaner;
a first cleaner storage that is provided outside of the substrate holder and temporarily stores the second cleaner;
a first holder movement device that moves the first cleaner holder; and
a controller that controls the first holder movement device with the first cleaner holder holding the first cleaner to clean the substrate held by the substrate holder, and after the first cleaner used for cleaning the substrate is detached from the first cleaner holder, controls the first holder movement device to connect the first connecting portion of the first cleaner holder to the first connected portion of the second cleaner temporarily stored in the first cleaner storage, wherein
the first holder movement device includes a first driver and a second driver that respectively move the first cleaner holder in a first direction and a second direction that are different from each other.

2. The substrate processing apparatus according to claim 1, wherein
the first direction extends along a first virtual line extending linearly in plan view, and
the second direction is a rotation direction about an axis intersecting with the first direction.

3. The substrate processing apparatus according to claim 1 or 2, further comprising a waiting pod that is provided outside of the substrate holder and is configured to accommodate the first cleaner and the second cleaner held by the first cleaner holder, wherein
the first holder movement device further moves the first cleaner holder to the waiting pod.

4. The substrate processing apparatus according to any one of claims 1 to 3, further comprising a detacher that is provided outside of the substrate holder and detaches the first cleaner and the second cleaner held by the first cleaner holder from the first cleaner holder, and
the first holder movement device further moves the first cleaner holder to the detacher.

5. The substrate processing apparatus according to claim 4, wherein
the first cleaner storage and the detacher are arranged to be adjacent to each other in plan view.

6. The substrate processing apparatus according to claim 2, further comprising:
a waiting pod that is provided outside of the substrate holder and is configured to accommodate the first cleaner and the second cleaner held by the first cleaner holder; and
a detacher that is provided outside of the substrate holder and detaches the first cleaner and the second cleaner held by the first cleaner holder from the first cleaner holder, wherein
the first holder movement device further moves the first cleaner holder to the waiting pod,
the substrate holder overlaps with the first virtual line in plan view,
the first cleaner holder, the waiting pod and the detacher overlap with a second virtual line intersecting with the first virtual line in plan view, and
at least portions of the first cleaner storage, the waiting pod and the detacher overlap with the first virtual line in plan view.

7. The substrate processing apparatus according to claim 2, further comprising:
a third cleaner and a fourth cleaner that respectively has second connected portions;
a second cleaner holder that has a second connecting portion that is attachable to and detachable from the second connected portions of the third cleaner and the fourth cleaner;
a second cleaner storage that is provided outside of the substrate holder, and temporarily stores the fourth cleaner; and
a second holder movement device that moves the second cleaner holder, wherein
the controller controls the second holder movement device with the second cleaner holder holding the third cleaner to clean the substrate held by the substrate holder, and after the third cleaner used for cleaning the substrate is detached from the second cleaner holder, controls the second holder movement device to connect the second connecting portion of the second cleaner holder to the second connected portion of the fourth cleaner temporarily stored in the second cleaner storage, and
the second holder movement device includes a third driver and a fourth driver that respectively move the second cleaner holder in a third direction and a fourth direction that are different from each other.

8. The substrate processing apparatus according to claim 7, wherein
the third direction is a same direction as the first direction,
the substrate holder overlaps with the first virtual line in plan view,
the first cleaner storage overlaps with a second virtual line intersecting with the first virtual line in plan view,
the second cleaner storage overlaps with a third virtual line that intersects with the first virtual line and is parallel to the second virtual line in plan view, and
the substrate holder is located between the second virtual line and the third virtual line in plan view.
